# EUROPEAN PATENT SPECIFICATION

(11) **EP 4 160 700 B1**
(45) Date of publication and mention of the grant of the patent: **05.03.2025**
(21) Application number: 21818487.7
(22) Date of filing: 20.04.2021
(51) Int. Cl.: H01L 27/15, H01L 33/14, H01L 25/075

(54) **LIGHT-EMITTING DEVICE AND DISPLAY APPARATUS**
LICHTEMITTIERENDE VORRICHTUNG UND ANZEIGEVORRICHTUNG
DISPOSITIF ÉLECTROLUMINESCENT ET APPAREIL D'AFFICHAGE

(30) Priority: 02.06.2020 JP 2020096343
(43) Date of publication of application: 05.04.2023
(73) Proprietor: Sony Group Corporation, Tokyo 108-0075 (JP)
(72) Inventor: OOHATA, Toyoharu, Tokyo 108-0075 (JP); KOYAMA, Takahiro, Tokyo 108-0075 (JP)
(74) Representative: D Young & Co LLP
(86) International application number: PCT/JP2021/015966
(87) International publication number: WO 2021/246068

(56) References cited:
- CN-A- 110 444 560
- JP-A- 2014 192 411
- JP-A- 2015 201 473
- KR-A- 20140 085 946
- US-A1- 2018 187 839
- US-A1- 2019 067 529
- US-A1- 2019 131 342
- US-A1- 2019 189 679

## Description

### Technical Field

The present disclosure relates to a light emitting device and a display apparatus.

### Background Art

Recently, an apparatus such as an illumination apparatus or an image display apparatus that includes a collection of multiple light emitting diodes (LEDs) has become widespread. For example, proposed is an LED display in which each of pixels includes three LEDs emitting respective pieces of light of red (R), green (G), and blue (B), and such pixels are disposed in a two-dimensional matrix. Proposed in addition is a color-conversion LED display in which a light source of the LED display includes a single-color LED array and phosphors emitting light of mutually different fluorescent colors are disposed cyclically on the single-color LED array (for example PTL 1). US 2019/067529 A1 and CN 110 444 560 A disclose light emitting devices according to the prior art.

### Citation List

### Patent Literature

PTL 1: Japanese Unexamined Patent Application Publication No. 2016-221316

### Summary of the Invention

Incidentally, in a color-conversion light emitting device, in a case where LEDs are reduced in size and a gap between mutually adjacent LEDs is reduced to increase a definition of pixels, light emitted from an LED enters a phosphor disposed at a position opposed to an adjacent LED, which easily causes optical crosstalk that causes the phosphor to emit light. In a case where such optical crosstalk occurs, color reproducibility is lowered. Accordingly, it is desirable to provide a light emitting device and a display apparatus that make it possible to suppress optical crosstalk.

A light emitting device according to an aspect of the present disclosure includes multiple light emitting elements. The light emitting elements each include a semiconductor layer including a first conductive layer, a light emitting layer, and a second conductive layer that are stacked in this order. The first conductive layer has a light emitting surface. The light emitting elements further includes a first electrode in contact with the second conductive layer, and a second electrode in contact with the first conductive layer. The light emitting elements each emit light from the light emitting layer via the light emitting surface. The light emitting elements share the first conductive layer and the second electrode with each other. The light emitting elements each include a current path in the first conductive layer from a portion opposed to the first electrode to a portion opposed to the second electrode. The first conductive layer has one or multiple trenches in a region between two current paths adjacent to each other. The light emitting device further includes a light blocking section provided in the one or multiple trenches.

A display apparatus according to an aspect of the present disclosure includes multiple pixels each including multiple light emitting elements. The light emitting elements each have the same configuration as the above-described light emitting element. The pixels each further include a light blocking section provided in the one or multiple trenches.

In the light emitting device and the display apparatus according to the aspect of the present disclosure, the first conductive layer is provided with the one or multiple trenches in the region between the two current paths adjacent to each other, and the light blocking section is provided in the one or multiple trenches. This makes it possible to reduce, by the light blocking section, leakage of the light emitted from the light emitting layer into the first conductive layer of the adjacent light emitting element while securing the current path in each of the light emitting elements.

### Brief Description of Drawings

[FIG. 1] FIG. 1 is a diagram illustrating a perspective configuration example of a display apparatus according to one embodiment of the present disclosure.
[FIG. 2] FIG. 2 is a diagram illustrating a functional block example of the display apparatus illustrated in FIG. 1.
[FIG. 3] FIG. 3 is a diagram illustrating a plan layout example of a mounting substrate illustrated in FIG. 1.
[FIG. 4] FIG. 4 is a diagram illustrating a circuit configuration example of each pixel illustrated in FIG. 3.
[FIG. 5A] FIG. 5A is a diagram illustrating a horizontal cross-sectional configuration example of a pixel chip illustrated in FIG. 3.
[FIG. 5B] FIG. 5B is a diagram illustrating a horizontal cross-sectional configuration example of the pixel chip illustrated in FIG. 3.
[FIG. 5C] FIG. 5C is a diagram illustrating a horizontal cross-sectional configuration example of the pixel chip illustrated in FIG. 3.
[FIG. 5D] FIG. 5D is a diagram illustrating a horizontal cross-sectional configuration example of the pixel chip illustrated in FIG. 3.
[FIG. 6A] FIG. 6A is a diagram illustrating a vertical cross-sectional configuration example of the pixel chip illustrated in FIG. 3.
[FIG. 6B] FIG. 6B is a diagram illustrating a vertical cross-sectional configuration example of the pixel chip illustrated in FIG. 3.
[FIG. 6C] FIG. 6C is a diagram illustrating a vertical cross-sectional configuration example of the pixel chip illustrated in FIG. 3.
[FIG. 6D] FIG. 6D is a diagram illustrating a vertical cross-sectional configuration example of the pixel chip illustrated in FIG. 3.
[FIG. 6E] FIG. 6E is a diagram illustrating a vertical cross-sectional configuration example of the pixel chip illustrated in FIG. 3.
[FIG. 7A] FIG. 7A is a cross-sectional view of an example of a method of manufacturing the pixel chip illustrated in FIG. 3.
[FIG. 7B] FIG. 7B is a cross-sectional view of an example of a manufacturing process following that illustrated in FIG. 7A.
[FIG. 7C] FIG. 7C is a diagram illustrating a top configuration example of FIG. 7B.
[FIG. 7D] FIG. 7D is a cross-sectional view of an example of a manufacturing process following that illustrated in FIG. 7B.
[FIG. 7E] FIG. 7E is a diagram illustrating a top configuration example of FIG. 7D.
[FIG. 7F] FIG. 7F is a cross-sectional view of an example of a manufacturing process following that illustrated in FIG. 7D.
[FIG. 7G] FIG. 7G is a diagram illustrating a top configuration example of FIG. 7F.
[FIG. 7H] FIG. 7H is a cross-sectional view of an example of a manufacturing process following that illustrated in FIG. 7F.
[FIG. 7I] FIG. 7I is a cross-sectional view of an example of a manufacturing process following that illustrated in FIG. 7H.
[FIG. 7J] FIG. 7J is a cross-sectional view of an example of a manufacturing process following that illustrated in FIG. 7I.
[FIG. 7K] FIG. 7K is a cross-sectional view of an example of a manufacturing process following that illustrated in FIG. 7J.
[FIG. 7L] FIG. 7L is a cross-sectional view of an example of a manufacturing process following that illustrated in FIG. 7K.
[FIG. 7M] FIG. 7M is a cross-sectional view of an example of a manufacturing process following that illustrated in FIG. 7L.
[FIG. 7N] FIG. 7N is a cross-sectional view of an example of a manufacturing process following that illustrated in FIG. 7M.
[FIG. 7O] FIG. 7O is a cross-sectional view of an example of a manufacturing process following that illustrated in FIG. 7N.
[FIG. 7P] FIG. 7P is a cross-sectional view of an example of a manufacturing process following that illustrated in FIG. 7O.
[FIG. 7Q] FIG. 7Q is a diagram illustrating a top configuration example of FIG. 7P.
[FIG. 7R] FIG. 7R is a cross-sectional view of an example of a manufacturing process following that illustrated in FIG. 7P.
[FIG. 7S] FIG. 7S is a cross-sectional view of an example of a manufacturing process following that illustrated in FIG. 7R.
[FIG. 7T] FIG. 7T is a cross-sectional view of an example of a manufacturing process following that illustrated in FIG. 7S.
[FIG. 7U] FIG. 7U is a cross-sectional view of an example of a manufacturing process following that illustrated in FIG. 7T.
[FIG. 7V] FIG. 7V is a cross-sectional view of an example of a manufacturing process following that illustrated in FIG. 7U.
[FIG. 7W] FIG. 7W is a cross-sectional view of an example of a manufacturing process following that illustrated in FIG. 7V.
[FIG. 7X] FIG. 7X is a cross-sectional view of an example of a manufacturing process following that illustrated in FIG. 7W.
[FIG. 7Y] FIG. 7Y is a cross-sectional view of an example of a manufacturing process following that illustrated in FIG. 7X.
[FIG. 8] FIG. 8 is a diagram schematically illustrating a light emission example in the pixel chip illustrated in FIG. 3.
[FIG. 9] FIG. 9 is a diagram illustrating a modification of a plan layout of the mounting substrate illustrated in FIG. 1.
[FIG. 10A] FIG. 10A is a diagram illustrating a horizontal cross-sectional configuration example of a pixel chip illustrated in FIG. 9.
[FIG. 10B] FIG. 10B is a diagram illustrating a horizontal cross-sectional configuration example of the pixel chip illustrated in FIG. 9.
[FIG. 10C] FIG. 10C is a diagram illustrating a horizontal cross-sectional configuration example of the pixel chip illustrated in FIG. 9.
[FIG. 10D] FIG. 10D is a diagram illustrating a horizontal cross-sectional configuration example of the pixel chip illustrated in FIG. 9.
[FIG. 11A] FIG. 11A is a diagram illustrating a vertical cross-sectional configuration example of the pixel chip illustrated in FIG. 9.
[FIG. 11B] FIG. 11B is a diagram illustrating a vertical cross-sectional configuration example of the pixel chip illustrated in FIG. 9.
[FIG. 11C] FIG. 11C is a diagram illustrating a vertical cross-sectional configuration example of the pixel chip illustrated in FIG. 9.
[FIG. 11D] FIG. 11D is a diagram illustrating a vertical cross-sectional configuration example of the pixel chip illustrated in FIG. 9.
[FIG. 11E] FIG. 11E is a diagram illustrating a vertical cross-sectional configuration example of the pixel chip illustrated in FIG. 9.
[FIG. 12] FIG. 12 is a diagram illustrating a modification of the horizontal cross-sectional configuration illustrated in FIG. 5B.
[FIG. 13] FIG. 13 is a diagram illustrating a modification of the horizontal cross-sectional configuration illustrated in FIG. 10B.
[FIG. 14] FIG. 14 is a diagram illustrating a modification of the horizontal cross-sectional configuration illustrated in FIG. 5B.
[FIG. 15] FIG. 15 is a diagram illustrating a modification of the horizontal cross-sectional configuration illustrated in FIG. 10B.
[FIG. 16] FIG. 16 is a diagram illustrating a modification of the vertical cross-sectional configuration of the pixel chip.
[FIG. 17] FIG. 17 is a diagram illustrating a modification of the vertical cross-sectional configuration of the pixel chip.
[FIG. 18] FIG. 18 is a diagram illustrating a modification of the vertical cross-sectional configuration of the pixel chip.
[FIG. 19] FIG. 19 is a diagram illustrating a modification of the vertical cross-sectional configuration of the pixel chip.
[FIG. 20] FIG. 20 is a diagram illustrating a modification of the vertical cross-sectional configuration of the pixel chip.
[FIG. 21] FIG. 21 is a diagram illustrating a modification of the vertical cross-sectional configuration of the pixel chip.
[FIG. 22] FIG. 22 is a diagram illustrating a modification of the vertical cross-sectional configuration of the pixel chip.
[FIG. 23] FIG. 23 is a diagram schematically illustrating a light emission example in the pixel chip illustrated in FIG. 19.
[FIG. 24] FIG. 24 is a diagram schematically illustrating a light emission example in the pixel chip illustrated in FIG. 20.
[FIG. 25] FIG. 25 is a diagram schematically illustrating a light emission example in the pixel chip illustrated in FIG. 21.
[FIG. 26] FIG. 26 is a diagram schematically illustrating a light emission example in the pixel chip illustrated in FIG. 22.
[FIG. 27] FIG. 27 is a diagram schematically illustrating a modification of a configuration of the pixel chip.
[FIG. 28] FIG. 28 is a diagram schematically illustrating a modification of the configuration of the pixel chip.

### Modes for Carrying Out the Invention

In the following, some embodiments of the present disclosure are described in detail with reference to the drawings. The following describes specific examples of the present disclosure, and the present disclosure is not limited to the following embodiments. In addition, the present disclosure is not limited to arrangements, dimensions, dimensional ratios, and the like of components illustrated in the drawings. It is to be noted that the description is given in the following order.

### 1. Embodiment (Display Apparatus)

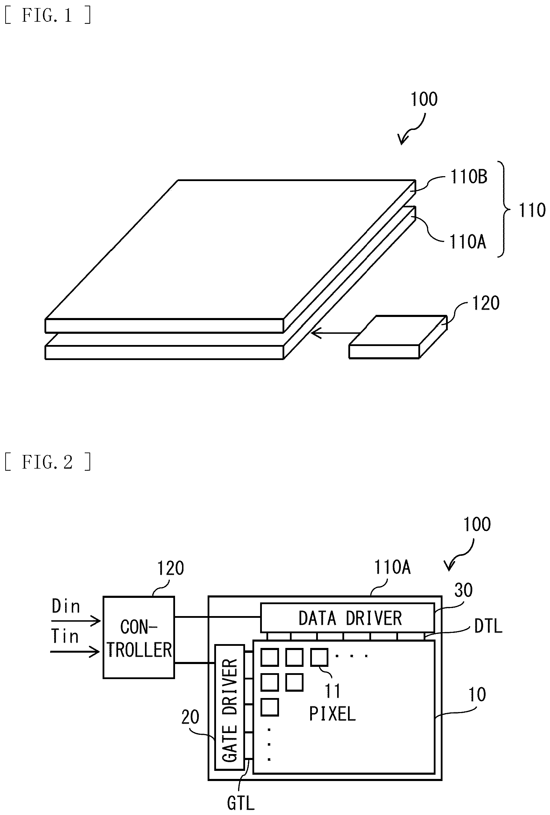

An example in which pieces of light having three respective colors are obtained from light emitting elements each emitting blue light ...... FIGs. 1 to 8

### 2. Modifications (Display Apparatus)

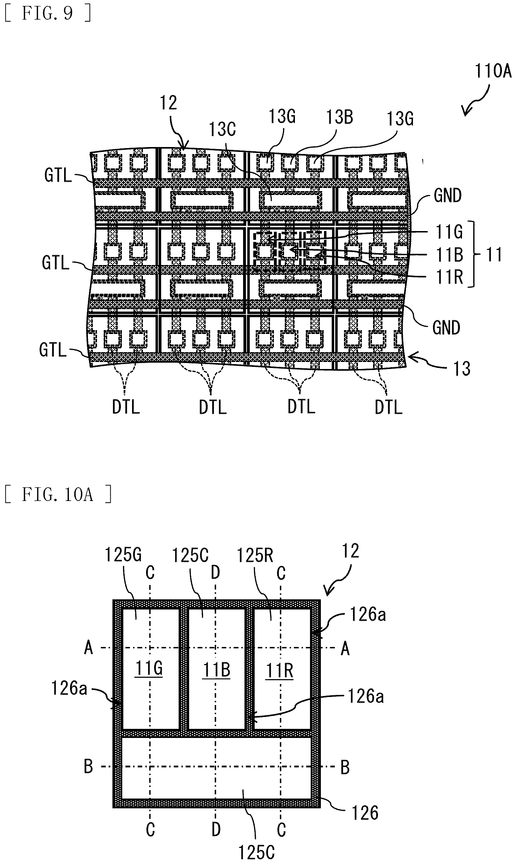

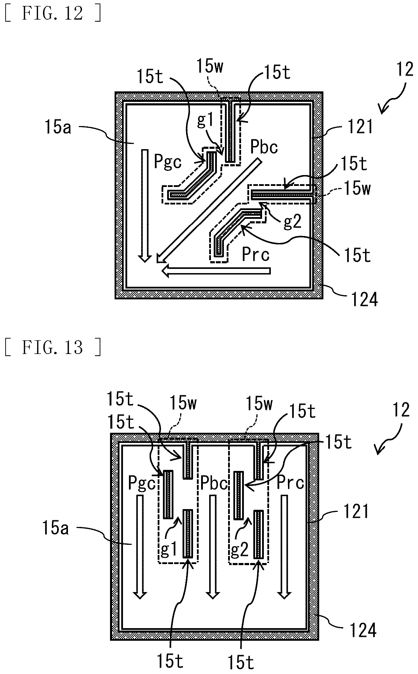

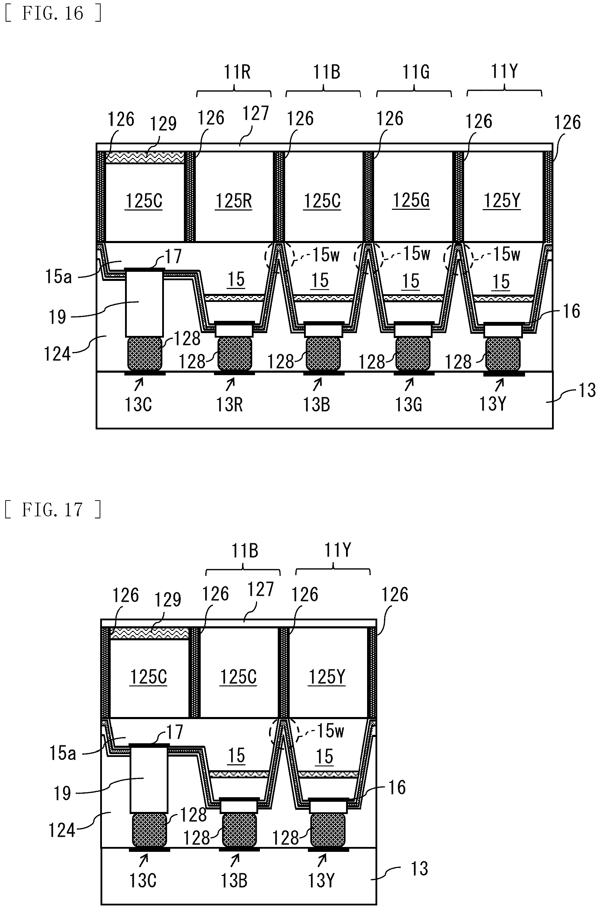

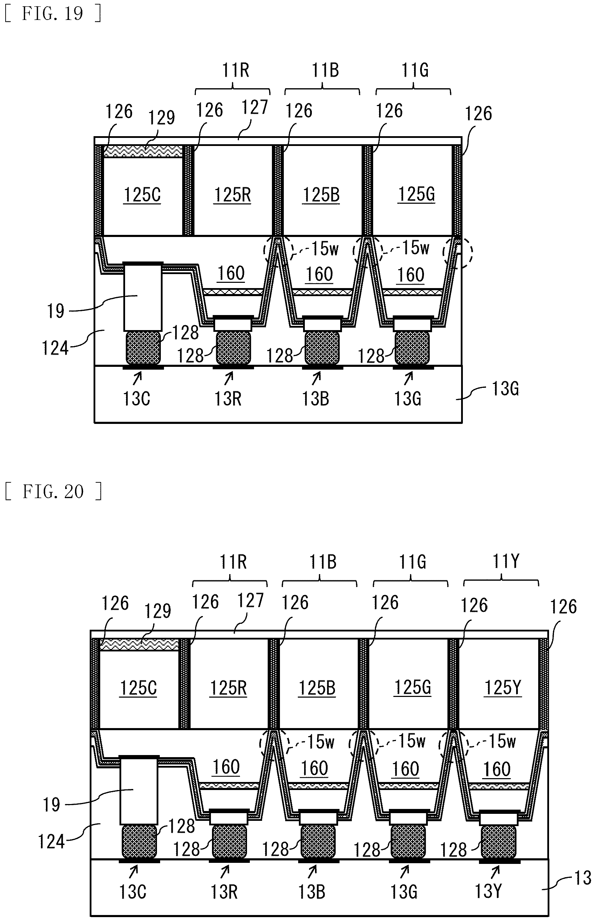

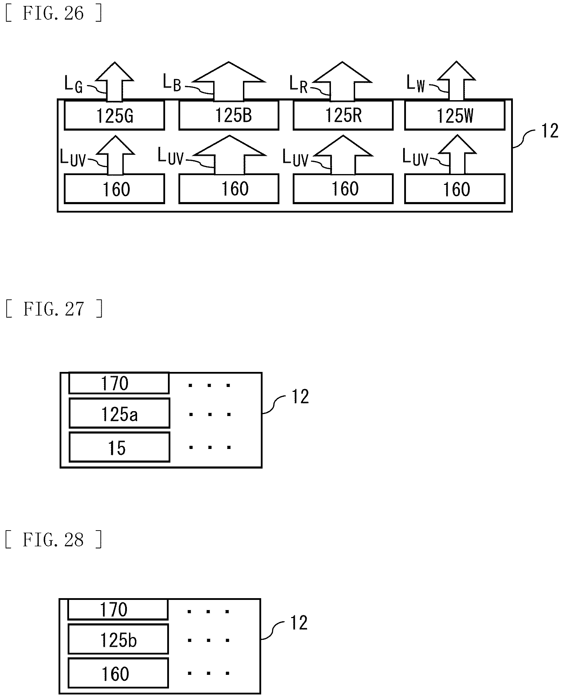

Modification A: An example in which light emitting elements are disposed in stripes ...... FIGs. 9 to 11E
Modification B: A variation of a way of disposing multiple light blocking sections ...... FIGs. 12 to 15
Modification C: A variation of the number of light emitting elements per one pixel chip ...... FIGs. 16 to 18
Modification D: An example using light emitting elements that each emit ultraviolet light ...... FIGs. 19 to 26
Modification E: An example provided with a color filter ...... FIGs. 27 and 28

### <1. Embodiment>

### [Configuration]

A description is given of a display apparatus 100 according to an embodiment of the present disclosure. FIG. 1 is a perspective view of an example of an outline configuration of the display apparatus 100 according to the present embodiment. The display apparatus 100 is a so-called LED display and uses LEDs for display pixels. For example, as illustrated in FIG. 1, the display apparatus 100 includes a display panel 110 and a controller 120 that controls driving of the display panel 110. The controller 120 controls the driving of the display panel 110, for example, on the basis of an image signal Din and a synchronization signal Tin supplied from an outside.

For example, as illustrated in FIG. 1, the display panel 110 includes a mounting substrate 110A and a transparent substrate 110B overlaid on the mounting substrate 110A. The transparent substrate 110B has a role of protecting light emitting elements 15 (which will be described later) included in the mounting substrate 110A, and includes, for example, a glass substrate, a resin substrate, or the like. For example, as illustrated in FIG. 2, the mounting substrate 110A includes a pixel array 10, a gate driver 20, and a data driver 30. The pixel array 10, the gate driver 20, and the data driver 30 are mounted, for example, on a wiring substrate 13 which will be described later. The gate driver 20 and the data driver 30 drive the pixel array 10 in accordance with a control performed by the controller 120 to thereby cause the pixel array 10 to display an image. The gate driver 20 is coupled to multiple gate lines GTL. The gate driver 20 drives the pixel array 10, for example, by sequentially applying a selection voltage to the multiple gate lines GTL. The data driver 30 is coupled to multiple data lines DTL. The data driver 30 drives the pixel array 10, for example, by applying a signal voltage corresponding to the image signal Din to the multiple data lines DTL.

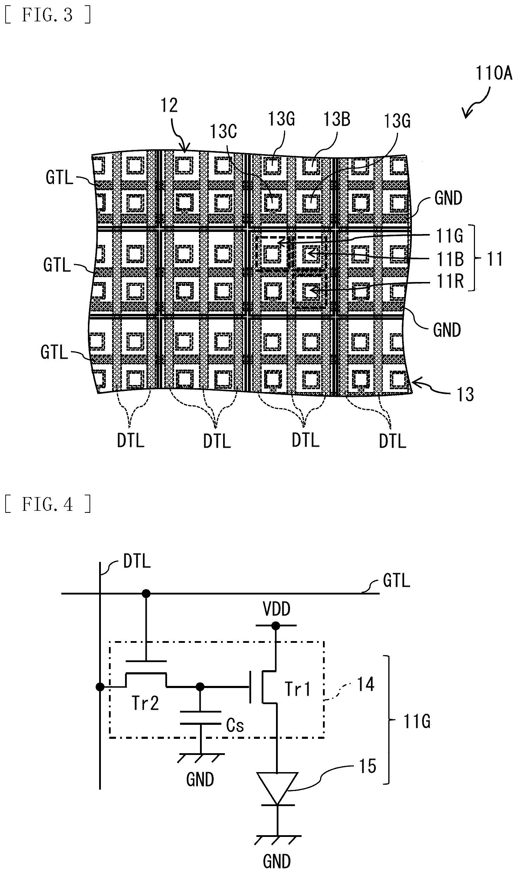

FIG. 3 illustrates an example of a plan layout of the mounting substrate 110A. Mounted on the mounting substrate 110A are multiple pixel chips 12 disposed in a matrix. The pixel chip 12 corresponds to a specific example of a "light emitting device" of the present disclosure. The pixel chip 12 has a size, for example, of 1 µm or greater and 100 µm or less, and is a so-called micro LED. It is to be noted that the pixel chip 12 may be, for example, a so-called mini LED having a size of greater than 100 µm and 200 µm or less. The pixel chip 12 is provided with one pixel 11. The pixel 11 includes, for example, three pixels 11G, 11B, and 11R that differ from each other in light emission color. That is, the pixel chip 12 includes, for example, the three pixels 11G, 11B, and 11R that differ from each other in the light emission color. In the pixel chip 12, the three pixels 11G, 11B, and 11R are disposed, for example, at three respective locations in a 2 × 2 matrix.

On a surface of the mounting substrate 110A on which each of the pixel chips 12 is mounted, for example, four electrodes (a G-electrode 13G, a B-electrode 13B, an R-electrode 13R, and a C-electrode 13C) are provided for each of the pixel chips 12. Coupled to the G-electrode 13G is a first electrode 16 (16G) of the pixel 11G in the pixel chip 12. Coupled to the B-electrode 13B is a first electrode 16 (16B) of the pixel 11B in the pixel chip 12. Coupled to the R-electrode 13R is a first electrode 16 (16R) of the pixel 11R in the pixel chip 12. Coupled to the C-electrode 13C is a second electrode 17 of each of the pixels 11G, 11B, and 11R in the pixel chip 12. The pixels 11G, 11B, and 11R share the second electrode 17 with each other. That is, each of the pixel chips 12 is provided with only one second electrode 17. On the mounting substrate 110A, the four electrodes (the G-electrode 13G, the B-electrode 13B, the R-electrode 13R, and the C-electrode 13C) are disposed, for example, in a 2 × 2 matrix.

The mounting substrate 110A is provided with, for example, the multiple gate lines GTL extending in a row direction, the multiple data lines DTL extending in a column direction, and multiple ground lines GND extending in the row direction. The multiple gate lines GTL are provided, for example, in such a manner that one multiple gate line GTL is provided per line of two or more pixel chips 12 disposed side by side in the row direction. The multiple data lines DTL are provided, for example, in such a manner that three data lines DTL are provided per line of two or more pixel chips 12 disposed side by side in the column direction. The multiple ground lines GND are provided, for example, in such a manner that one ground line GND is provided per line of two or more pixel chips 12 disposed side by side in the row direction.

FIG. 4 illustrates a circuit configuration example of each of the pixels 11G, 11B, and 11R. Each of the pixels includes the light emitting element 15 and a pixel circuit 14 that controls light emission and light extinction of the light emitting element 15. The light emitting element 15 is, for example, a light emitting diode (LED) that emits light (blue light) in a blue band having a light emission wavelength of 430 nm or greater and 500 nm or less. The pixel circuit 14 includes, for example, a driving transistor Tr1, a writing transistor Tr2, and a holding capacitor Cs. The writing transistor Tr2 controls a voltage to be applied to a gate of the driving transistor Tr1. The writing transistor Tr2 samples a voltage of the data line DTL and writes the voltage obtained by the sampling to the gate of the driving transistor Tr1. The holding capacitor Cs is coupled to the gate of the driving transistor Tr1 and the ground line GND, and holds a gate voltage of the driving transistor Tr1. The driving transistor Tr1 is coupled in series to a power supply voltage VDD and the light emitting element 15. The driving transistor Tr1 drives the light emitting element 15. The driving transistor Tr1 controls a current flowing through the light emitting element 15 in accordance with the voltage supplied to the gate of the driving transistor Tr1. That is, the pixel circuit 14 causes a current corresponding to a signal voltage supplied from the data driver 30 to flow into the light emitting element 15, thereby causing the light emitting element 15 to emit light having a luminance corresponding to the signal voltage supplied from the data driver 30. The circuit of each of the pixels 11G, 11B, and 11R is not limited to the circuit illustrated in FIG. 4.

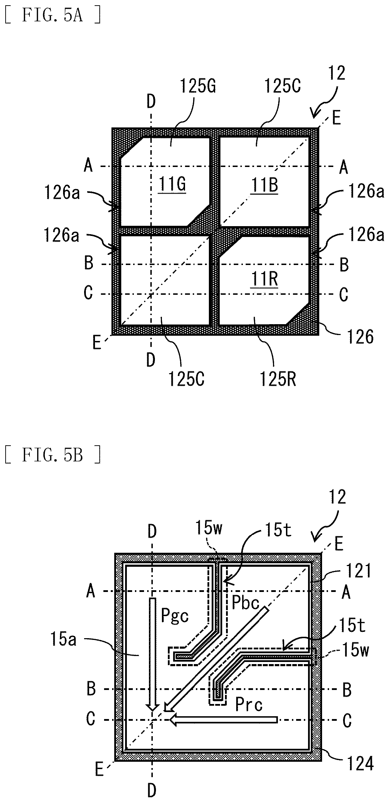

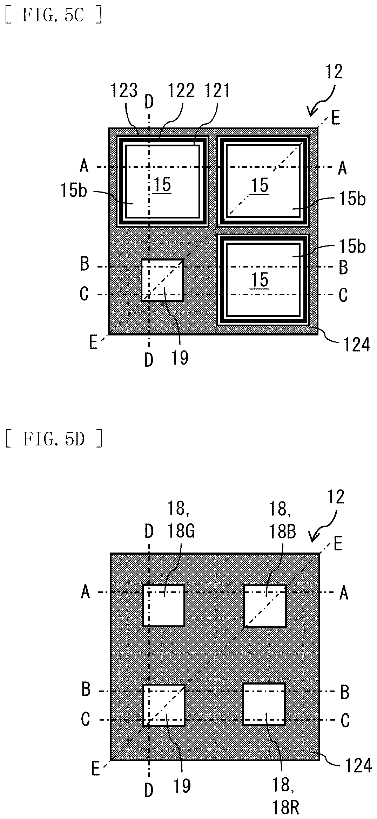

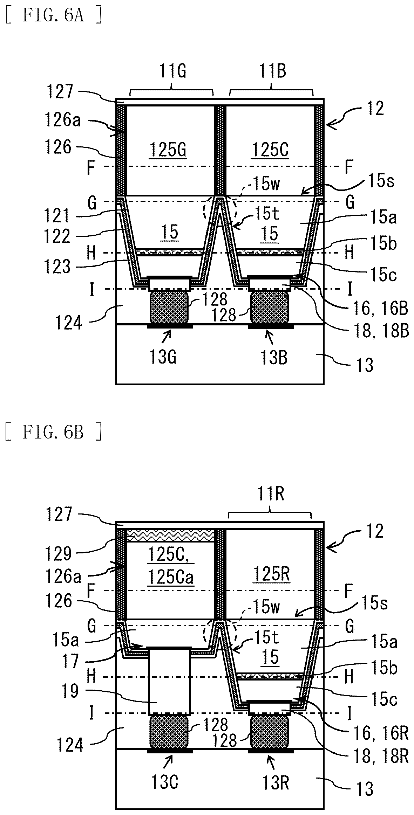

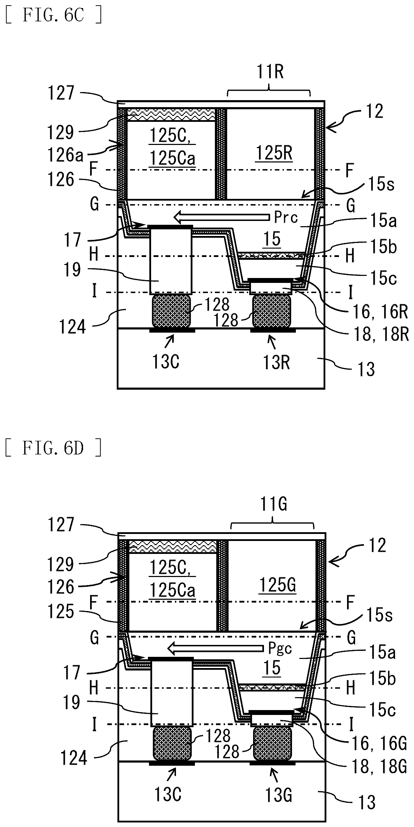

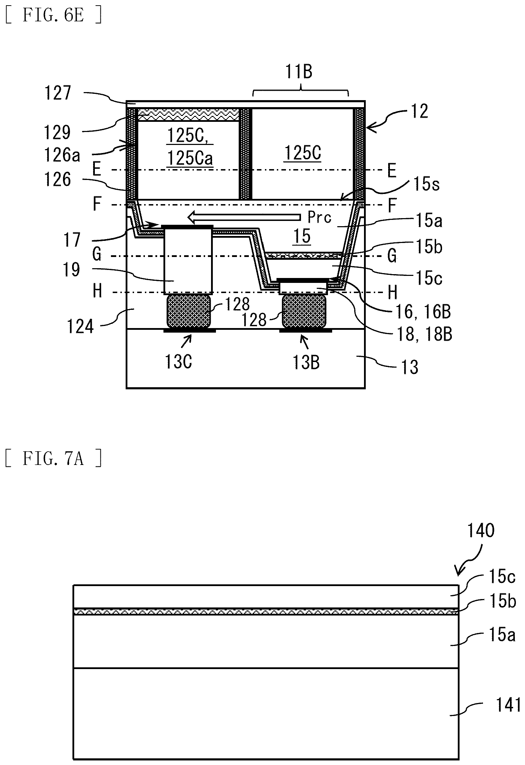

FIGs. 5A to 5D each illustrate a horizontal cross-sectional configuration example of the pixel chip 12. FIGs. 6A to 6E each illustrate a vertical cross-sectional configuration example of the pixel chip 12. The horizontal cross-section refers to a cross-section parallel to a light emitting surface 15s which will be described later, and the vertical cross-section refers to a cross-section perpendicular to the light emitting surface 15s. FIG. 5A illustrates a cross-sectional configuration example taken along a line F-F in each of FIGs. 6A to 6E. FIG. 5B illustrates a cross-sectional configuration example taken along a line G-G in each of FIGs. 6A to 6E. FIG. 5C illustrates a cross-sectional configuration example taken along a line H-H in each of FIGs. 6A to 6E. FIG. 5D illustrates a cross-sectional configuration example taken along a line I-I in each of FIGs. 6A to 6E. FIG. 6A illustrates a cross-sectional configuration example taken along a line A-A in each of FIGs. 5A to 5D. FIG. 6B illustrates a cross-sectional configuration example taken along a line B-B in each of FIGs. 5A to 5D. FIG. 6C illustrates a cross-sectional configuration example taken along a line C-C in each of FIGs. 5A to 5D. FIG. 6D illustrates a cross-sectional configuration example taken along a line D-D in each of FIGs. 5A to 5D. FIG. 6E illustrates a cross-sectional configuration example taken along a line E-E in each of FIGs. 5A to 5D.

As described above, the pixel chip 12 includes the three pixels 11G, 11B, and 11R. In the pixel chip 12, the pixels 11G, 11B, and 11R include the respective light emitting elements 15 that emit light of the same color (blue light) regardless of the kinds of the pixels, and include respective optical members, on the light emitting surfaces 15s of the light emitting elements 15, that differ from each other in color conversion function. That is, in the pixel chip 12, the pixels 11G, 11B, and 11R are configured to emit, by means of the optical members, respective pieces of light that differ from each other in the light emission color.

For example, as illustrated in FIGs. 6A and 6D, the pixel 11G includes the light emitting element 15 and a color conversion section 125G provided on the light emitting surface 15s of the light emitting element 15. The color conversion section 125G corresponds to the above-described optical member. The color conversion section 125G is provided in correspondence with the light emitting element 15 provided immediately below the color conversion section 125G. The light emitting element 15 emits light (blue light) toward the color conversion section 125G via the light emitting surface 15s. The color conversion section 125G performs color conversion (wavelength conversion) on the blue light emitted from the corresponding light emitting element 15. The color conversion section 125G converts the entering blue light into green light, and emits the green light obtained by the color conversion to an opposite side to a light emitting element 15 side. The pixel 11G emits green light having a desired light emission intensity due to driving of the pixel circuit 14 by the gate driver 20 and the data driver 30.

For example, as illustrated in FIG. 6A, the pixel 11B includes the light emitting element 15 and a light transmitting section 125C provided on the light emitting surface 15s of the light emitting element 15. The light transmitting section 125C corresponds to the above-described optical member. The light transmitting section 125C is provided in correspondence with the light emitting element 15 provided immediately below the light transmitting section 125C. The light emitting element 15 emits light (blue light) toward the light transmitting section 125C via the light emitting surface 15s. The light transmitting section 125C transmits the blue light emitted from the corresponding light emitting element 15. The light transmitting section 125C transmits the entering blue light, and emits the entering blue light to an opposite side to a light emitting element 15 side. That is, it is not intended that the light transmitting section 125C performs color conversion. The pixel 11B emits blue light having a desired light emission intensity due to driving of the pixel circuit 14 by the gate driver 20 and the data driver 30.

For example, as illustrated in FIGs. 6B and 6C, the pixel 11R includes the light emitting element 15 and a color conversion section 125R provided on the light emitting surface 15s of the light emitting element 15. The color conversion section 125R corresponds to the above-described optical member. The color conversion section 125R is provided in correspondence with the light emitting element 15 provided immediately below the color conversion section 125R. The light emitting element 15 emits light (blue light) toward the color conversion section 125R via the light emitting surface 15s. The color conversion section 125R performs color conversion (wavelength conversion) on the blue light emitted from the corresponding light emitting element 15. The color conversion section 125R converts the entering blue light into red light, and emits the red light obtained by the color conversion to an opposite side to a light emitting element 15 side. The pixel 11R emits red light having a desired light emission intensity due to driving of the pixel circuit 14 by the gate driver 20 and the data driver 30.

### (Light Emitting Element 15)

For example, as illustrated in FIGs. 6A to 6E, the light emitting element 15 includes a semiconductor layer including a first conductive layer 15a, a light emitting layer 15b, and a second conductive layer 15c that are stacked in this order. The first conductive layer 15a has the light emitting surface 15s. The above-described semiconductor layer includes, for example, a single-crystal multilayered film including GaN, InGaN, and AlGaN. The first conductive layer 15a includes, for example, an n-type semiconductor. The light emitting layer 15b includes, for example, a non-doped semiconductor. The second conductive layer 15c includes, for example, a p-type semiconductor.

For example, as illustrated in FIGs. 6A to 6E, the light emitting element 15 further includes the first electrode 16 in contact with the second conductive layer 15c and the second electrode 17 in contact with the first conductive layer 15a. The first electrode 16 is in ohmic contact with the second conductive layer 15c. The first electrode 16 includes, for example, a stacked film (Ni/Au) of nickel (Ni) and gold (Au) or a stacked film (Pd/Au) of palladium (Pd) and gold (Au). The first electrode 16 may include, for example, a single-layer film of platinum (Pt), or may include a stacked film including ITO (Indium Tin Oxide) in contact with the second conductive layer 15c and a metal layer in contact with the ITO. The second electrode 17 is in ohmic contact with the first conductive layer 15a. The second electrode 17 includes, for example, a stacked film (Ti/Al) of titanium (Ti) and aluminum (Al), or a stacked film (Cr/Au) of chromium (Cr) and gold (Au).

For example, as illustrated in FIGs. 6C to 6E, in the above-described semiconductor layer, a portion of the first conductive layer 15a, the light emitting layer 15b, and the second conductive layer 15c form a mesa part protruding toward a wiring substrate 13 side. The first electrode 16 is disposed at the top of the mesa part and the second electrode 17 is disposed at the bottom of the mesa part. That is, the second electrode 17 is provided on a surface of the first conductive layer 15a on an opposite side to the light emitting surface 15s, and the first electrode 16 and the second electrode 17 are provided on a surface of the pixel chip 12 on an opposite side to a light emitting surface 15s side.

For example, as illustrated in FIGs. 6C to 6E, the second electrode 17 is shared by the light emitting elements 15 in the pixel chip 12. In addition, for example, as illustrated in FIG. 5B, the first conductive layer 15a is shared by the light emitting elements 15 in the pixel chip 12. That is, in the pixel chip 12, the first conductive layers 15a of the respective light emitting elements 15 are integrally formed. Each of the light emitting elements 15 has a current path P in the first conductive layer 15a from a portion opposed to the first electrode 16 to a portion opposed to the second electrode 17. For example, as illustrated in FIGs. 5B and 6C, the light emitting element 15 of the pixel 11G has a current path Pgc in the first conductive layer 15a from a portion opposed to the first electrode 16G to a portion opposed to the second electrode 17. For example, as illustrated in FIGs. 5B and 6D, the light emitting element 15 of the pixel 11B has a current path Pbc in the first conductive layer 15a from a portion opposed to the first electrode 16B to a portion opposed to the second electrode 17. For example, as illustrated in FIGs. 5B and 6E, the light emitting element 15 of the pixel 11R has a current path Prc in the first conductive layer 15a from a portion opposed to the first electrode 16R to a portion opposed to the second electrode 17. That is, in the pixel chip 12, the first conductive layer 15a has the three current paths Pgc, Pbc, and Prc extending radially from the portion opposed to the second electrode 17.

The first conductive layer 15a has a trench 15t in a region between the two current paths Pgc and Pbc that are adjacent to each other. In addition, the first conductive layer 15a has another trench 15t in a region between the two current paths Pbc and Prc adjacent to each other. The trench 15t is formed, for example, by etching the first conductive layer 15a from the opposite side to the light emitting surface 15s side, and is provided, for example, to run through the first conductive layer 15a. In a case where the trench 15t is provided to run through the first conductive layer 15a, no current flows across the trench 15t in the first conductive layer 15a. In a case where the trench 15t is provided at a depth at which the trench 15t does not run through the first conductive layer 15a, a cross-sectional area of a portion having the trench 15t is less than a cross-sectional area of other portions in the first conductive layer 15a, and it is difficult for a current to flow in the portion having the trench 15t in the first conductive layer 15a. It is to be noted that, for example, the trench 15t may be formed by etching the first conductive layer 15a from the light emitting surface 15s side.

An electrode 18G is provided in contact with the first electrode 16G of the pixel 11G. An electrode 18B is provided in contact with the first electrode 16B of the pixel 11B. An electrode 18R is provided in contact with the first electrode 16R of the pixel 11R. An electrode 19 is provided in contact with the second electrode 17 shared by the pixels 11G, 11B, and 11R. The electrode 19 has a bottom surface in the same plane as bottom surfaces of the electrodes 18 (18G, 18B, and 18R). Each of the bottom surfaces of the electrodes 18 (18G, 18B, and 18R) and the electrode 19 is provided with a metal bump 128. The pixel chip 12 is electrically coupled to the wiring substrate 13 via each of the metal bumps 128. It is to be noted that solder balls may be provided in place of the metal bumps 128.

In addition, for example, as illustrated in FIGs. 5B, 6A, and 6B, the pixel chip 12 includes a light blocking section 15w in each of the trenches 15t formed in the first conductive layer 15a. The light blocking section 15w is provided at least on the light emitting surface 15s side in the trench 15t. For example, the light blocking section 15w is provided along an inner wall in the trench 15t. A side surface of each of the light emitting elements 15 corresponds to the inner wall in the trench 15t. For example, the light blocking section 15w may be provided not only along the inner wall in the trench 15t but also along a portion of the bottom surface of the light emitting element 15 that is not covered with the electrode 18. In this case, in terms of light leakage prevention, the light blocking section 15w may include a material that absorbs the light (the blue light) emitted from the light emitting layer 15b. Examples of such a material include a resin in which a light absorbing material such as carbon particles is dispersed (a so-called black resist).

In terms of an improvement in light extraction efficiency, the light blocking section 15w may serve as a reflection mirror that reflects the light (the blue light) emitted from the light emitting layer 15b. In addition, in terms of the improvement in light extraction efficiency, the side surface of each of the light emitting elements 15 may have a tapered shape when viewed from the light emitting surface 15s side, and the light blocking section 15w may serve as a reflection mirror that reflects the light (the blue light) emitted from the light emitting layer 15b toward the light emitting surface 15s side. It is to be noted that the light blocking section 15w may be provided in such a manner as to fill in the trench 15t.

In order to serve as the reflection mirror, for example, the light blocking section 15w may include a multilayered film in which an insulation film 121, a metal film 122, and an insulation film 123 are stacked in this order from the side surface of the light emitting element 15. The insulation films 121 and 123 each include, for example, a dielectric such as SiO₂ or Al₂O₃. In terms of the improvement in light extraction efficiency of the light emitting element 15, for example, the metal film 122 may have a high reflectance with respect to the light (the blue light) emitted from the light emitting layer 15b. Examples of the material having such a characteristic include Al, Ag, Au, Cu, Ni, Ti, W, Pd, and an alloy including at least two materials from among them. For example, the metal film 122 may include Al, Ag, Au, Cu, Ni, Ti, W, Pd, or a multilayered film including at least two materials from among them.

It is to be noted that the light blocking section 15w may include a material having a low reflectance and a high light absorption property (e.g., a carbon dispersion resin, a low-reflection metal compound, a metal oxide, a color dispersion resin, or the like).

### (Color Conversion Sections 125G and 125R)

For example, each of the color conversion sections 125G and 125R absorbs excitation light (the blue light) emitted from the light emitting element 15 and performs wavelength conversion on the excitation light. The color conversion sections 125G and 125R each include, for example, a block in which multiple quantum-dot phosphors are fixed with a resin binder. The color conversion sections 125G and 125R may each further include, for example, a light scatterer that scatters the excitation light (the blue light) emitted from the light emitting element 15. The light scatterer includes, for example, a material having a refractive index different from a refractive index of the resin included in each of the color conversion sections 125G and 125R.

The quantum-dot phosphor absorbs the excitation light (the blue light) emitted from the light emitting element 15 and emits fluorescent light. The quantum-dot phosphor included in the color conversion section 125G is, for example, a phosphor in a particle form that emits fluorescent light having a wavelength of green that is 500 nm or greater and 550 nm or less. The quantum-dot phosphor included in the color conversion section 125R is, for example, a phosphor in a particle form that emits fluorescent light having a wavelength of red that is 610 nm or greater and 780 nm or less. The quantum-dot phosphor includes, for example, a solid solution or a multilayered structure including one or more kinds of materials selected from CdS, CdSe, ZnS, ZnSe, InAgS, and CsPbClₓBr₃₋ₓ. The quantum-dot phosphor may be, for example, phosphor particles of an oxide, a fluoride, or a nitride that are dispersed and fixed, or may be an organic phosphor.

To supply the quantum-dot phosphor, for example, an inkjet-type or needle-type dispenser is used to discharge or apply the quantum-dot phosphor depending on a viscosity of the resin mixed with the quantum-dot phosphor. This is classified as a non-plate printing method, and the above-described method enables to selectively fill an inside of a barrier with the quantum-dot phosphor, therefore making it possible to increase use efficiency of the quantum-dot phosphor. The resin including the quantum-dot phosphor may be applied to a predetermined place by a screen printing technique, a gravure printing technique, or the like that is a plate-type printing method. Alternatively, the resin including the quantum-dot phosphor may be applied to the entire base, for example, by a spin coater or the like.

The resin to be mixed with the quantum-dot phosphor is a resin for uniformly dispersing the quantum-dot phosphor, and includes, for example, a material having light transparency with respect to the light (the blue light) emitted from the light emitting element 15. The resin to be mixed with the quantum-dot phosphor includes, for example, an acrylic-based, epoxy-based, or silicone-based resin material.

### (Light Transmitting Section 125C)

The light transmitting section 125C includes, for example, a material having a light transmitting property with respect to the light (the blue light) emitted from the light emitting element 15. The light transmitting section 125C includes, for example, an acrylic-based, epoxy-based, or silicone-based resin material.

For example, as illustrated in FIGs. 6B to 6E, the pixel chip 12 further includes, other than the light transmitting section 125C provided in the pixel 11B, another light transmitting section 125C (hereinafter, referred to as a "light transmitting section 125Ca" when it is distinguished from the light transmitting section 125C provided in the pixel 11B) on a portion of the top surface of the first conductive layer 15a that is opposed to the second electrode 17. For example, as illustrated in FIGs. 6B to 6E, the pixel chip 12 further includes a light blocking layer 129 that covers a surface of the light transmitting section 125Ca on an opposite side to a first conductive layer 15a side. The light blocking layer 129 prevents light from leaking to the outside via the light transmitting section 125Ca. The light blocking layer 129 includes, for example, a material having a low reflectance and a high light absorption property (e.g., a carbon dispersion resin, a low-reflection metal compound, a metal oxide, a color dispersion resin, or the like).

For example, as illustrated in FIGs. 5A and 6A to 6E, the pixel chip 12 further includes a light blocking section 126 that partitions the color conversion section 125G, the color conversion section 125R, the light transmitting section 125C, and the light transmitting section 125Ca from each other. The light blocking section 126 includes, for example, a material having a high reflectance with respect to visible light. Examples of a material having such a characteristic include Al, Ag, Cu, Ni, Cr, W, Ti, and an alloy including at least two materials from among them. The light blocking section 126 may include, for example, a material that absorbs visible light. Examples of a material having such a characteristic include a resin in which a light absorbing material such as carbon particles is dispersed (a so-called black resist). The light blocking section 126 may include, for example, a partition including an organic resin, a dielectric (such as SiO₂ or Al₂O₃), a semiconductor (such as Si), or the like; and a reflection layer 126a including a material formed on a side surface of the partition and having a high reflectance with respect to visible light.

For example, as illustrated in FIGs. 6A to 6E, the pixel chip 12 may further include a protection layer 127 on an as-needed basis. For example, the protection layer 127 has a role of protecting the respective surfaces of the color conversion section 125G, the color conversion section 125R, the light transmitting section 125C, and the light blocking layer 129; and a role of sealing the color conversion section 125G and the color conversion section 125R with respect to oxygen, moisture, or the like. The protection layer 127 is provided in contact with the respective top surfaces of the color conversion section 125G, the color conversion section 125R, the light transmitting section 125C, and the light blocking layer 129. The protection layer 127 includes, for example, for example, SiN, Al₂O₃, AlN, ZrO₂, Ta₂O₃, TiO₂, ZnO, or the like.

In the pixel chip 12, the three first electrodes 16 (16G, 16B, and 16R) each included in the corresponding one of the pixels 11G, 11B, and 11R, and the second electrode 17 shared by the pixels 11G, 11B, and 11R are disposed, for example, in a 2 × 2 matrix. In this case, the three first electrodes 16 (16G, 16B, and 16R) and the second electrode 17 are the same as each other in size, for example.

### [Manufacturing Method]

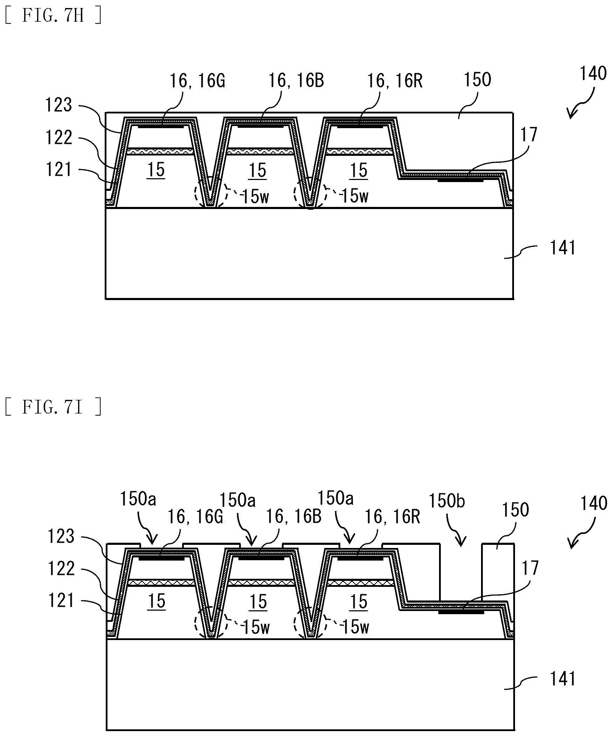

Next, a description is given of a method of manufacturing the mounting substrate 110A. FIGs. 7A to 7Y each illustrate an example of a process of manufacturing the mounting substrate 110A.

First, compound semiconductors are formed together on a semiconductor substrate 141, for example, by an epitaxial crystal growth method such as an MOCVD (Metal Organic Chemical Vapor Deposition: metal organic chemical vapor deposition) method. Upon using the epitaxial crystal growth method such as the MOCVD method, for example, trimethylgallium ((CH₃)₃Ga) is used as a raw-material gas for gallium; for example, trimethylindium ((CH₃)₃In) is used as a raw-material gas for indium; trimethylaluminum ((CH₃)₃Al) is used as a raw-material for aluminum; and ammonia (NH₃) is used as a raw-material gas for nitrogen. Further, for example, monosilane (SiH₄) is used as a raw-material gas for silicon; and for example, bis(cyclopentadienyl)magnesium ((C₅H₅)₂Mg) is used as a raw-material gas for magnesium.

First, the first conductive layer 15a, the light emitting layer 15b, and the second conductive layer 15c are formed in this order on a surface of the semiconductor substrate 141, for example, by an epitaxial crystal growth method such as a MOCVD method (FIG. 7A). Thus, a light emitting element substrate 140 is formed.

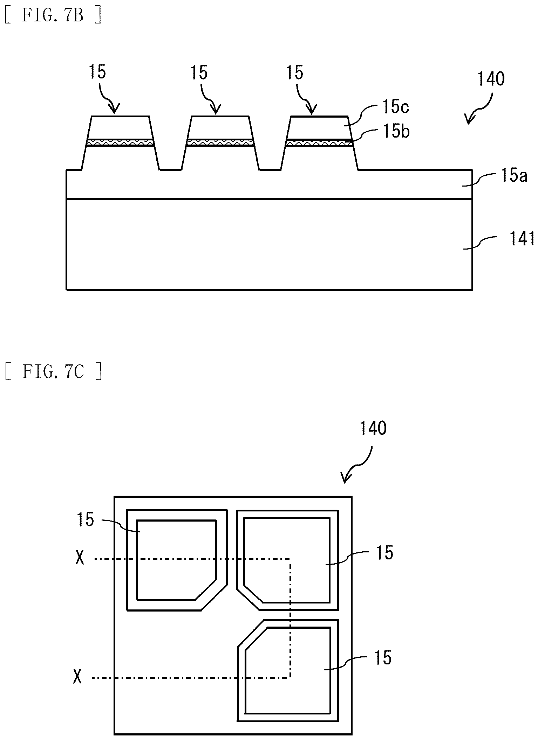

Thereafter, for example, a resist layer (not illustrated) having a predetermined pattern is formed, following which the second conductive layer 15c, the light emitting layer 15b, and a portion of the first conductive layer 15a are selectively etched using this resist layer as a mask. Thus, for example, as illustrated in FIG. 7B, multiple mesa parts each having a column shape are formed. In this case, each of the mesa parts serves as the light emitting element 15. For example, a plan configuration in this case is as illustrated in FIG. 7C. It is to be noted that a cross-sectional configuration example taken along a line X-X in FIG. 7C corresponds to a cross-sectional view illustrated in FIG. 7B. Every three mesa parts (the light emitting elements 15) of the multiple mesa parts (the light emitting elements 15) formed on the light emitting element substrate 140 are disposed at three respective locations in a 2 × 2 matrix. For example, each of the three mesa parts (the light emitting elements 15) disposed at the three respective locations in the 2 × 2 matrix has a substantially square shape in a plan view, and has a shape with a notch at a portion corresponding to the middle of the 2 × 2 matrix.

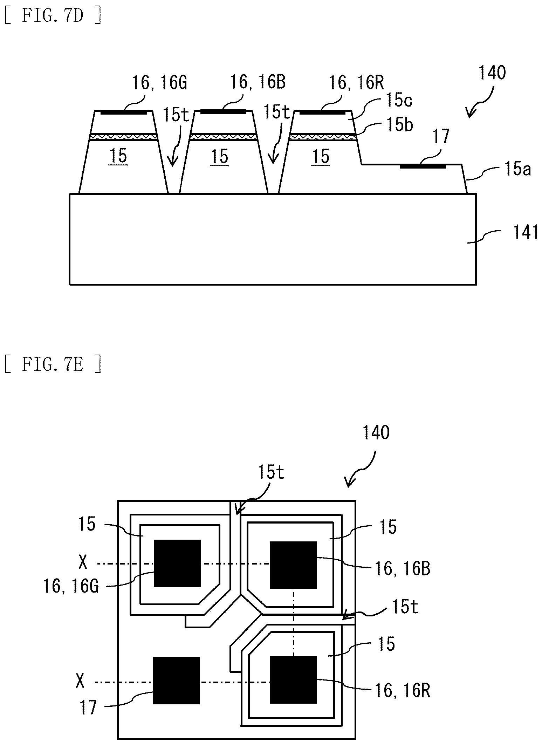

Thereafter, the first electrode 16 and the second electrode 17 are formed (FIG. 7D). The first electrode 16 is in contact with the top (the top surface of the second conductive layer 15c) of each of the mesa parts (the light emitting elements 15), and the second electrode 17 is in contact with the bottom (the top surface of the first conductive layer 15a) of each of the mesa parts (the light emitting elements 15). Thereafter, for example, a resist layer (not illustrated) having a predetermined pattern is formed, following which etching is performed selectively on the first conductive layer 15a using the resist layer as a mask at: a gap portion between two mesa parts (the light emitting elements 15) adjacent to each other in the row direction (hereinafter, referred to as a "first gap portion"); a gap portion between two mesa parts (the light emitting elements 15) adjacent to each other in the column direction (hereinafter, referred to as a "second gap portion"); a portion along the notch of the mesa part (the light emitting element 15) provided at (1, 1) in the 2 × 2 matrix; and a portion along the notch of the mesa part (the light emitting element 15) provided at (2, 2) in the 2 × 2 matrix. Thus, for example, as illustrated in FIGs. 7D and 7E, two trenches 15t are formed in the first conductive layer 15a. It is to be noted that FIG. 7E is a plan configuration example of FIG. 7D. FIG. 7D is a cross-sectional configuration example taken along a line X-X in FIG. 7E. At this time, each of the trenches 15t runs through the first conductive layer 15a, for example, as illustrated in FIG. 7D. It is to be noted that, at this time, each of the trenches 15t may have a depth to the extent at which the trench 15t does not run through the first conductive layer 15a.

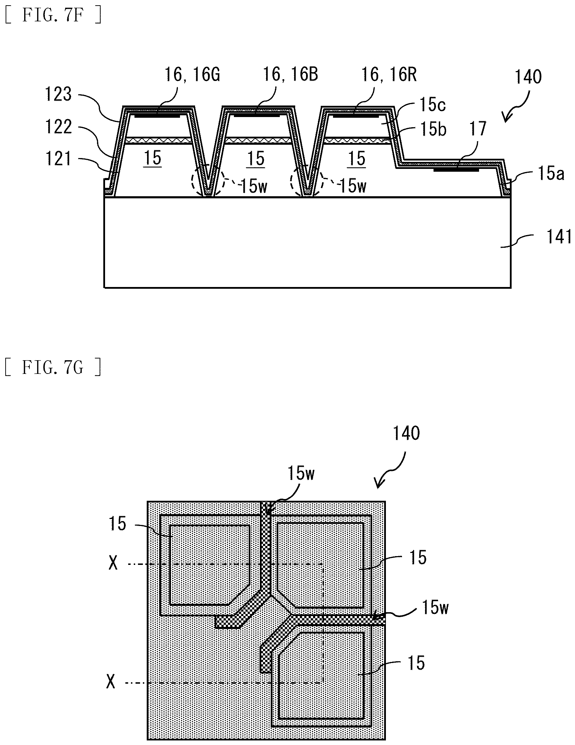

Thereafter, the insulation film 121, the metal film 122, and the insulation film 123 are stacked in this order on the entire surface including the inner wall of each of the trenches 15t (FIGs. 7F and 7G). It is to be noted that FIG. 7F is a plan configuration example of FIG. 7F. FIG. 7F is a cross-sectional configuration example taken along a line X-X in FIG. 7G. Thus, the light blocking section 15w is formed in each of the trenches 15t. In this case, a predetermined gap is formed between the two trenches 15t (the light blocking sections 15w), and the gap becomes a portion of the current path Pbc.

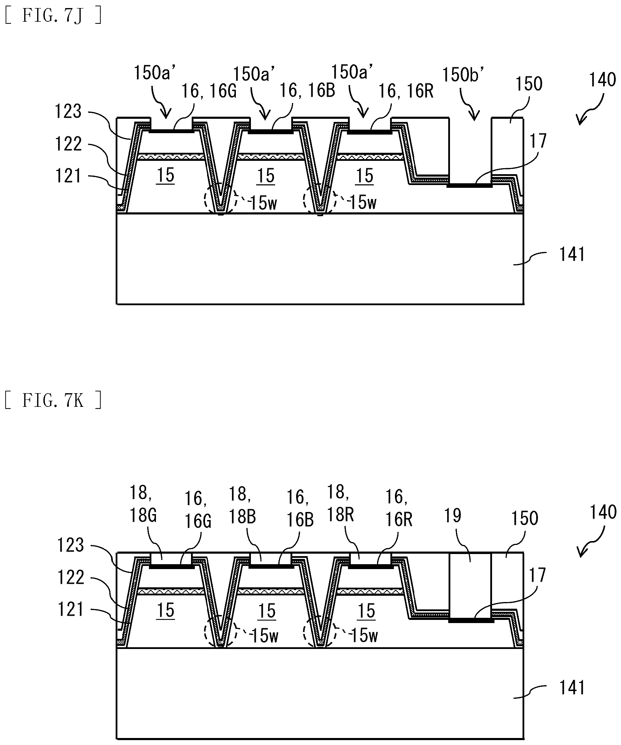

Thereafter, a resist layer 150 is formed to embed the insulation film 123 therein, following which an opening is formed at a predetermined portion in the resist layer 150. For example, an opening 150a is formed at a portion of the resist layer 150 opposed to the first electrode 16 (16G, 16B, or 16R) of each of the mesa parts (the light emitting elements 15), and an opening 150b is formed at a portion opposed to the second electrode 17 (FIG. 7I). Thereafter, the insulation film 121, the metal film 122, and the insulation film 123 are selectively etched using the resist layer 150 as a mask. Thus, openings 150a' and 150b' are formed in the multilayered film including the insulation film 121, the metal film 122, and the insulation film 123 (FIG. 7J). In this case, the first electrode 16 (16G, 16B, or 16R) is exposed at a bottom surface of each of the openings 150a', and the second electrode 17 is exposed at a bottom surface of the opening 150b'.

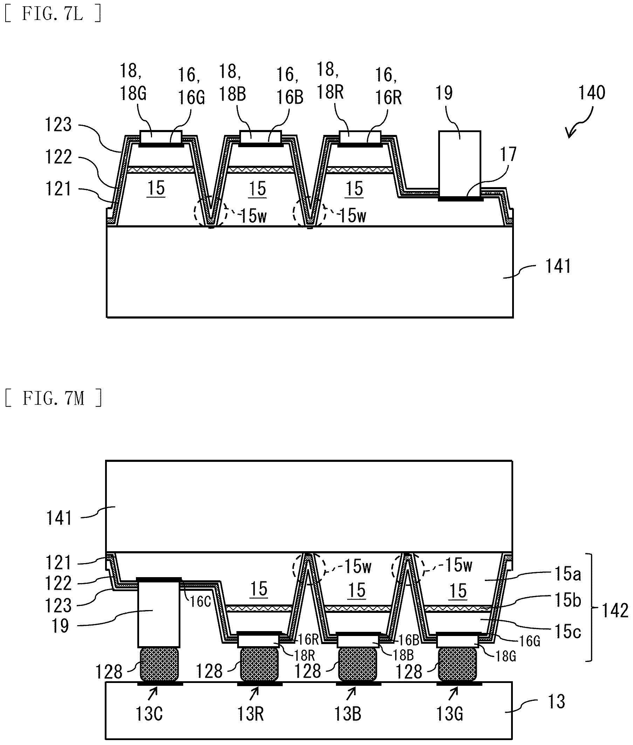

Thereafter, for example, the electrode 18 (18G, 18B, or 18R) is formed in each of the openings 150a' and the electrode 19 is formed in the opening 150b' by a plating process (FIG. 7K). Thereafter, the resist layers 150 is removed (FIG. 7L).

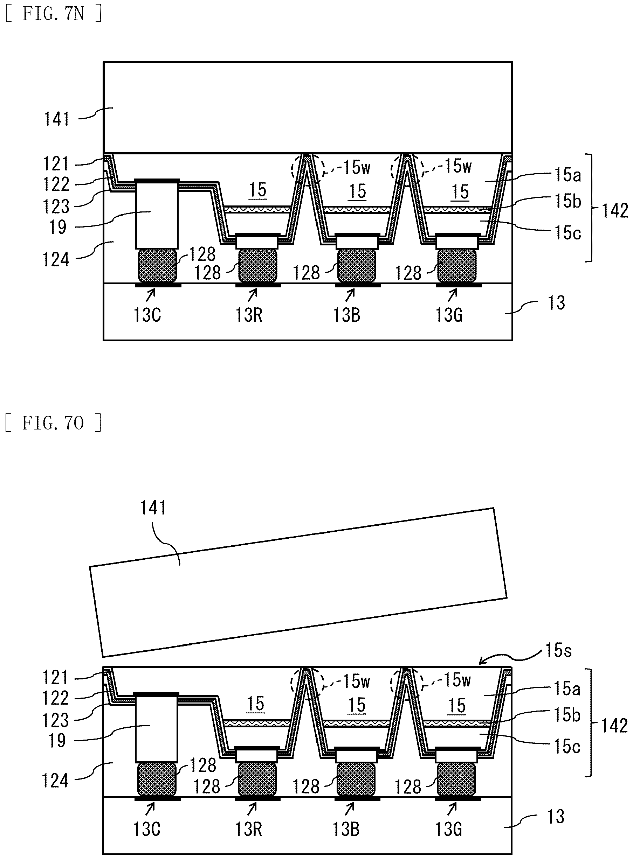

Thereafter, for example, the light emitting element substrate 140 is mounted on the wiring substrate 13 in a state where each of the mesa parts (the light emitting elements 15) are directed toward the wiring substrate 13 side on which the metal bumps 128 are formed (FIG. 7M). Thus, the light emitting element substrate 140 and the wiring substrate 13 are bonded to each other with the multiple metal bumps 128 interposed therebetween. Thereafter, gaps between the light emitting element substrate 140 and the wiring substrate 13 are filled with a resin material such as polyimide to form an embedding layer 124 (FIG. 7N). Thereafter, the semiconductor substrate 141 is removed from a light emitting element layer 142 including the multiple light emitting elements 15 (FIG. 7O). Thus, the light emitting surface 15s of each of the light emitting elements 15 is exposed.

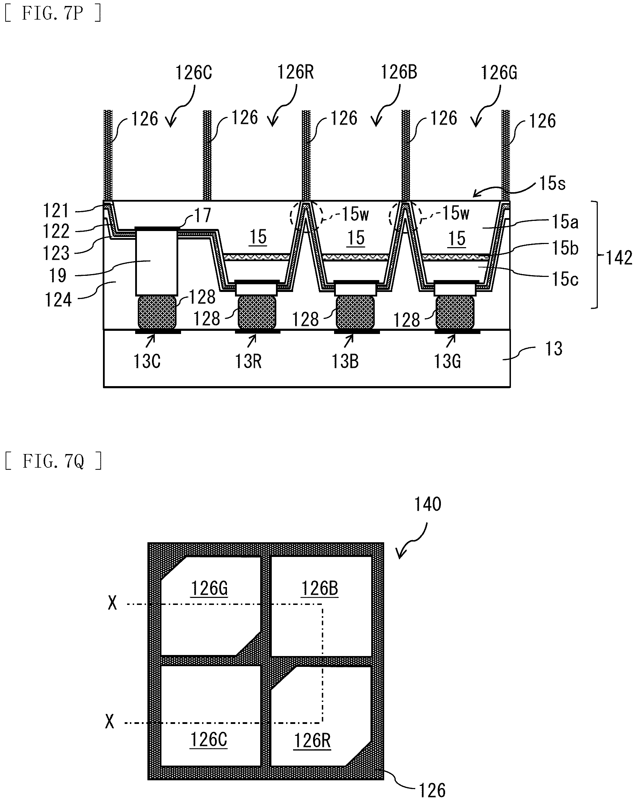

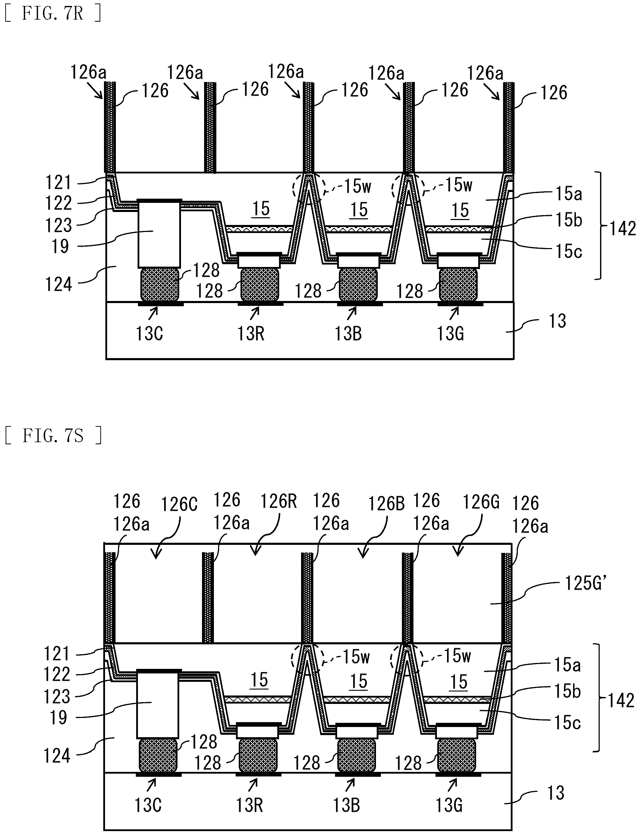

Thereafter, for example, the light blocking section 126 is formed on a surface including the light emitting surface 15s of each of the light emitting elements 15 (FIGs. 7P and 7Q). It is to be noted that FIG. 7Q illustrates a plan configuration example of FIG. 7P. FIG. 7P illustrates a cross-sectional configuration example taken along a line X-X in FIG. 7Q. The light blocking section 126 is provided with openings 126G, 126B, and 126R at respective portions opposed to the light emitting elements 15. The light emitting surface 15s (the first conductive layer 15a) of the light emitting element 15 is exposed at the bottom surface of each of the openings 126G, 126B, and 126R. The light blocking section 126 is further provided with an opening 126C at a portion opposed to the second electrode 17 (the electrode 19). The first conductive layer 15a of the light emitting element 15 is exposed at the bottom surface of the opening 126C. It is to be noted that the reflection layer 126a may be provided in contact with an inner wall of the light blocking section 126 (an inner wall of each of the openings 126G, 126B, 126R, and 126C) on an as-needed basis (FIG. 7R).

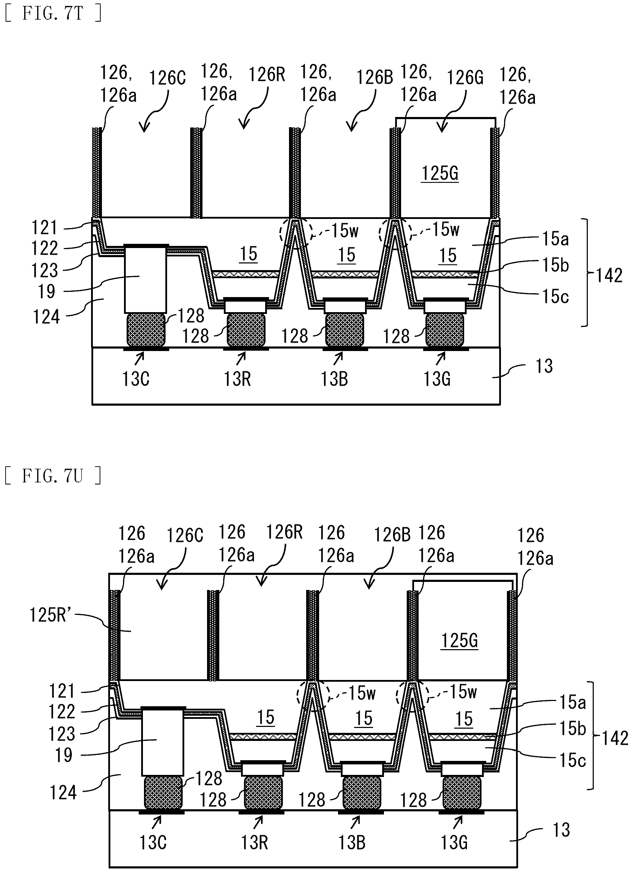

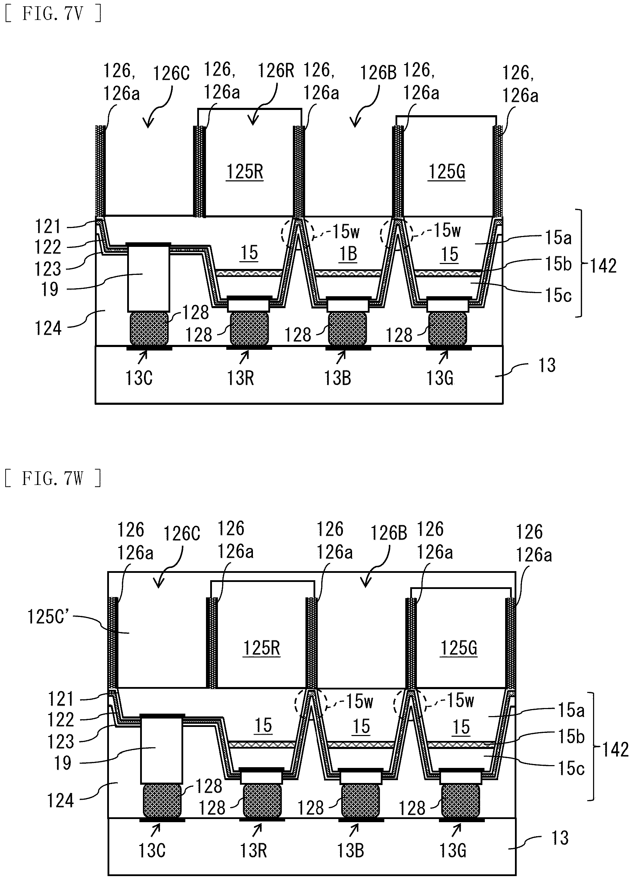

Thereafter, for example, a resin 125G' in which at least multiple quantum-dot phosphors are dispersed is applied to the entire surface having the openings 126G, 126B, 126R, and 126C (FIG. 7S). Thereafter, the resin 125G' is left only in the opening 126G opposed to the light emitting element 15 on the G-electrode 13G. Thus, the color conversion section 125G is formed in the opening 126G (FIG. 7T). Thereafter, for example, a resin 125R' in which at least multiple quantum-dot phosphors are dispersed is applied to the entire surface having the openings 126B, 126R, and 126C (FIG. 7U). Thereafter, the resin 125R' is left only in the opening 126R opposed to the light emitting element 15 on the R-electrode 13R. Thus, the color conversion section 125R is formed in the opening 126R (FIG. 7V).

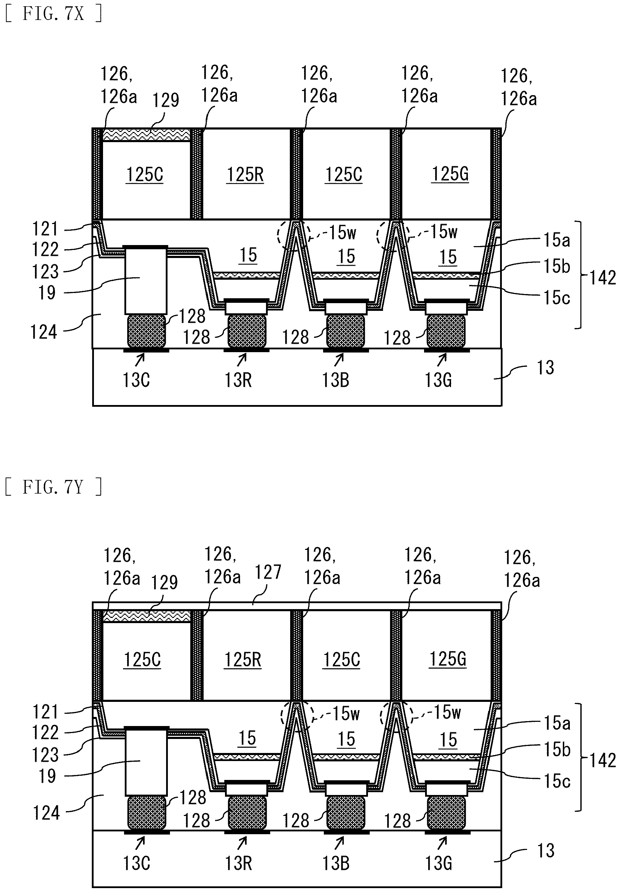

Thereafter, for example, a resin 125C' including no quantum-dot phosphor is applied to the entire surface having the openings 126R and 126C (FIG. 7W). Thereafter, the resin 125C' is left only in the openings 126G and 126C opposed to the light emitting elements 15 on the electrodes 13B and 13C. Thus, the light transmitting section 125C is formed in each of the openings 126G and 126C (FIG. 7X). In addition, a top portion of the light transmitting section 125C provided at a location opposed to the C-electrode 13C is removed to provide a recess, and the light blocking layer 129 is formed in the recess (FIG. 7X). Thereafter, the entire surface is planarized, following which the protection layer 127 is formed on the planarized surface (FIG. 7Y). Thus, the multiple pixel chips 12 are formed on the wiring substrate 13. Lastly, the gate driver 20 and the data driver 30 are mounted on the wiring substrate 13 at portions in which no pixel chip 12 is formed. Thus, the mounting substrate 110A is formed.

### [Operation]

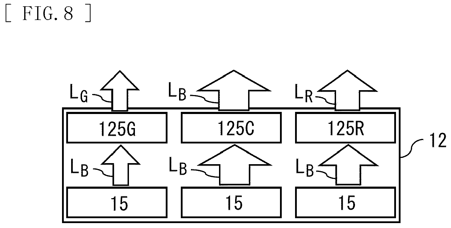

Next, an operation of the display apparatus 100 is described. Each of the light emitting elements 15 in the pixel chip 12 is driven by the gate driver 20 and the data driver 30 to thereby emit blue light L_{B} having a predetermined light emission intensity, for example, as illustrated in FIG. 8. The blue light L_{B} emitted from the first light emitting element 15 in the pixel chip 12 is converted into green light L_{G} by the color conversion section 125G, and the converted light (the green light L_{G}) is emitted to the outside as light of the pixel 11G. In addition, the blue light L_{B} emitted from the second light emitting element 15 in the pixel chip 12 passes through the light transmitting section 125C, and is emitted to the outside as light of the pixel 11B. The blue light L_{B} emitted from the third light emitting element 15 in the pixel chip 12 is converted into red light L_{R} by the color conversion section 125R, and the converted light (the red light L_{R}) is emitted to the outside as light of the pixel 11R. Three pieces of light (the green light L_{G}, the blue light L_{B}, and the red light L_{R}) that differ from each other in the light emission color are emitted at predetermined respective intensities from each of the pixel chips 12 disposed on the mounting substrate 110A. The three pieces of light (the green light L_{G}, the blue light L_{B}, and the red light L_{R}) that differ from each other in the light emission color and are emitted from each of the pixel chips 12 disposed on the mounting substrate 110A form image light. Entering of the image light into the retina of the user allows the user to recognize that an image is displayed on the display panel 110.

### [Effects]

Next, effects of the display apparatus 100 are described.

A display apparatus (an LED display) in which light emitting diodes (LED: Light Emitting Diode) having respective colors of red, green, and blue are used as pixels and are disposed in a two-dimensional matrix has been put into practical use and widely used. For each of the light emission colors, light emitting diodes are fabricated by forming, by crystal growth, a semiconductor multilayered film with a controlled band gap and a controlled conductivity type on a single-crystal substrate; performing a process such as electrode formation; and dividing the resultant by a dicing apparatus into pieces for the respective elements. A display apparatus has been manufactured by mounting each individualized piece of the element on a wiring substrate or a drive circuit board by a mechanical apparatus such as a chip mounter. Therefore, it has been difficult to increase definition, for example, to have a pixel arrangement cycle (a pixel pitch) of about 1 mm or less.

To address the above, recently, the definition has been increased to have a pixel arrangement cycle from 1 mm or less to several tens micrometers due to a decrease in element size by optical patterning and etching and due to development of a method of collectively mounting multiple fine elements with use of a bonding material or the like. However, even in such a method, re-arrangement of LEDs having different light emission colors on the same substrate limits a decrease in size. For example, to obtain a light-weighted head mounted display, it is desired to make the display size to be about 20 mm × 15 mm or less; and to provide pixels of about 640 × 480 or more, it is required to make the pixel arrangement cycle to be about 30 µm or less. To arrange and mount the LEDs having three colors in such a cycle, it is necessary to use an extremely highly accurate mounting apparatus for alignment and mounting. This results in a great increase in manufacturing cost as compared with an existing (liquid crystal or organic EL) display apparatus formed monolithically.

Meanwhile, as a more effective method for achieving a higher definition, consideration has been given to fabricating a multi-color display apparatus by forming an LED array with LEDs having a single color and alternately disposing on the LED array wavelength converters emitting mutually different fluorescent colors. In this case, for example, if each pixel includes three LEDs and a cathode electrode and an anode electrode are provided for each of the LEDs, it is necessary to couple six electrodes and a drive circuit board with each other for each pixel. In addition, for example, if each pixel includes three LEDs and if the LEDs in each pixel share a cathode-side conductive layer thereof and also share the cathode electrode, it is sufficient that four electrodes and the drive circuit board are coupled to each other in each pixel. In such a case, it is easier to increase the definition of the pixels.

However, in a case where the conductive layer is integrated as described above, optical crosstalk easily occurs in which light emitted from one LED propagates through the integrated conductive layer and enters a wavelength converter provided for another LED. In a case where such optical crosstalk occurs, color reproducibility is lowered.

In contrast, in the present embodiment, the first conductive layer 15a is provided with the trench 15t in the region between the two current paths Pgc and Pbc adjacent to each other, and is also provided with the trench 15t in the region between the two current paths Pbc and Prc adjacent to each other. In addition, the light blocking section 15w is provided in each of the trenches 15t. This makes it possible, in each of the light emitting elements 15, to reduce, by means of the light blocking section 15w, leakage of light emitted from the light emitting layer 15b into the first conductive layer 15a of the adjacent light emitting element 15, while securing the current path. As a result, it is possible to suppress optical crosstalk.

In the present embodiment, the light emitting elements 15 share the second electrode 17, and only one second electrode 17 is provided in the pixel chip 12. This makes it possible to reduce the number of electrodes per pixel chip 12, as compared with a case where the light emitting elements 15 are provided separately and the second electrode 17 is provided for each of the light emitting elements 15. As a result, it is possible to reduce the size of the pixel chip 12, and is also possible to suppress occurrence of defects due to a bonding error in mounting or the like.

**In** the present embodiment, each of the trenches 15t is provided to run through the first conductive layer 15a, and the light blocking section 15w is provided at least on the light emitting surface 15s side in each of the trenches 15t. This makes it possible to reduce, by means of the light blocking section 15w, leakage of the light emitted from the light emitting layer 15b into the first conductive layer 15a of the adjacent light emitting element 15. As a result, it is possible to suppress optical crosstalk.

**In** the present embodiment, in a case where the light blocking section 15w is provided along the inner wall in each of the trenches 15t and serves as a reflection mirror that reflects the light emitted from the light emitting layer 15b, the light emitted from the light emitting layer 15b is reflected by the light blocking section 15w. This makes it possible to reduce leakage of the light emitted from the light emitting layer 15b into the first conductive layer 15a of the adjacent light emitting element 15. As a result, it is possible to suppress optical crosstalk.

In the present embodiment, each of the pixel chips 12 is provided with the color conversion sections 125G and 125R. The color conversion section 125G performs color conversion on blue light emitted from the light emitting element 15 provided in correspondence with the color conversion section 125G, and the color conversion section 125R performs color conversion on blue light emitted from the light emitting element 15 provided in correspondence with the color conversion section 125R. This allows for providing the multiple light emitting elements 15 emitting light of the same color in a common semiconductor layer. Accordingly, it is possible to reduce the size of the pixel chip 12, as compared with a case where the light emitting elements are formed separately. In addition, it is possible to reduce, by means of the light blocking section 15w formed in each of the trenches 15t formed in the common semiconductor layer (the first conductive layer 15a), leakage of light emitted from each of the light emitting elements 15 into the first conductive layer 15a of the adjacent light emitting element 15. As a result, it is possible to suppress optical crosstalk while reducing the size of the pixel chip 12.

In the present embodiment, in a case where the color conversion sections 125G and 125R each include the block including the multiple quantum-dot phosphors and the light scatterer, light (blue light) incident on each of the color conversion sections 125G and 125R is scattered by the light scatterer. It is therefore possible to cause the phosphor to efficiently absorb the blue scattered light. This increases the conversion efficiency in the color conversion sections 125G and 125R as compared with a case with no light scatterer. Therefore, it is possible to decrease the intensity of the light (the blue light) to enter each of the color conversion sections 125G and 125R, as compared with the case with no light scatterer. In such a case, it is possible to reduce the amount of light leaking into the first conductive layer 15a of the adjacent light emitting element 15. As a result, it is possible to suppress optical crosstalk.

In the present embodiment, even in a case where each of the color conversion sections 125G and 125R includes a block in which multiple quantum-dot phosphors are fixed with a resin binder but includes no light scatterer, the light emitted from the light emitting layer 15b is blocked by the light blocking section 15w and it is possible to reduce leakage of the light emitted from the light emitting layer 15b into the first conductive layer 15a of the adjacent light emitting element 15. As a result, it is possible to suppress optical crosstalk.

In the present embodiment, the second electrode 17 is provided on the surface on the opposite side to the light emitting surface 15s of the first conductive layer 15a. This makes it possible to electrically couple each of the light emitting elements 15 included in the light emitting element layer 142 and the wiring substrate 13 to each other, for example, only by bonding the light emitting element layer 142 to the wiring substrate 13, as illustrated in FIG. 7M. Accordingly, even in a case where the definition of pixels is increased, it is possible to suppress occurrence of defects due to a bonding error in mounting or the like.

### <2. Modifications>

Next, a description in given of modifications of the display apparatus 100 according to the embodiment described above.

### [Modification A]

FIG. 9 illustrates an example of the plan layout of the mounting substrate 110A in the display apparatus 100 according to the embodiment described above. Mounted on the mounting substrate 110A are the multiple pixel chips 12 disposed in a matrix. The pixel chip 12 has the size, for example, of 1 µm or greater and 100 µm or less, and is a so-called micro LED. It is to be noted that the pixel chip 12 may be, for example, a so-called mini LED having a size of greater than 100 µm and 200 µm or less. The pixel chip 12 is provided with one pixel 11.

The pixel 11 includes, for example, the three pixels 11G, 11B, and 11R that differ from each other in the light emission color. That is, the pixel chip 12 includes, for example, the three pixels 11G, 11B, and 11R that differ from each other in the light emission color. In the pixel chip 12, the three pixels 11G, 11B, and 11R are disposed, for example, side by side in one line in the column direction.

On the mounting substrate 110A, the three electrodes (the G-electrode 13G, the B-electrode 13B, and the R-electrode 13R) are disposed, for example, side by side in one line in the column direction, and the C-electrode 13C is disposed, for example, adjacent, in the column direction, to the three electrodes (the G-electrode 13G, the B-electrode 13B, and the R-electrode 13R) disposed side by side in one line in the column direction.

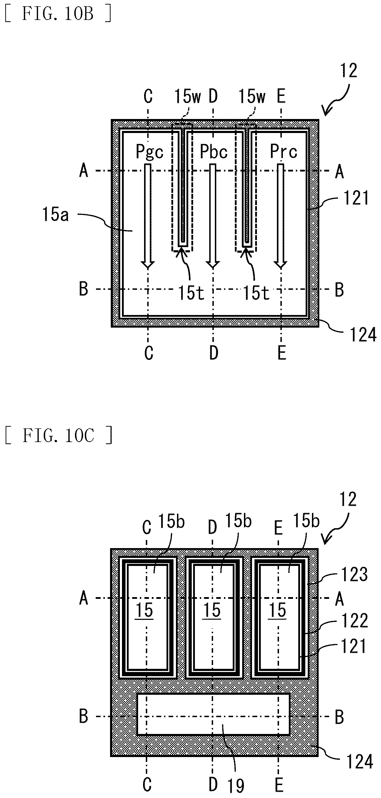

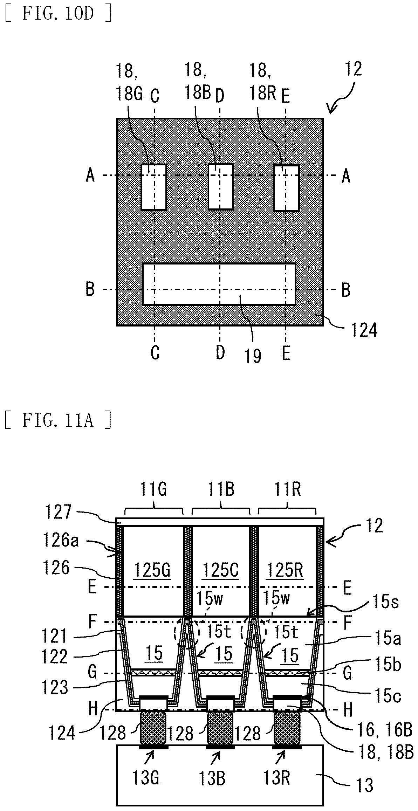

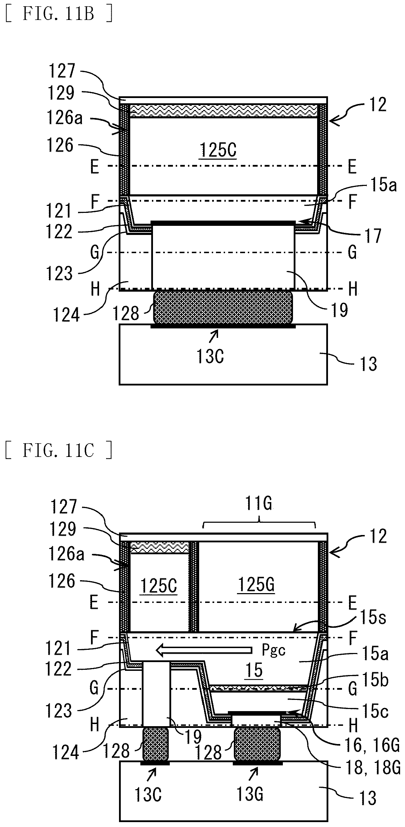

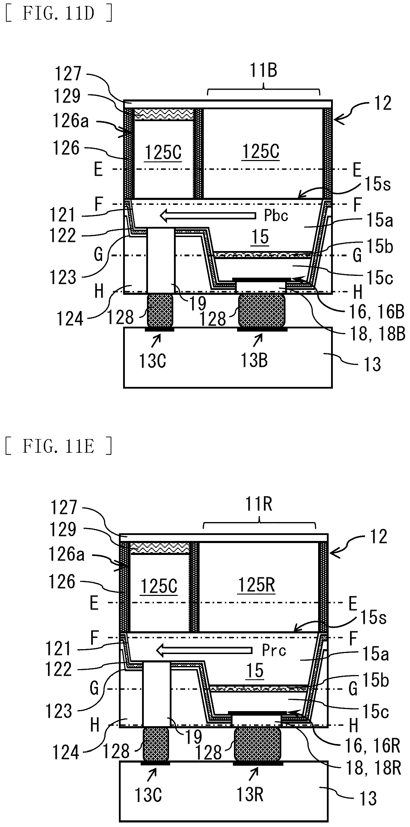

FIGs. 10A to 10D each illustrate a horizontal cross-sectional configuration example of the pixel chip 12 according to the present modification. FIGs. 11A to 11E each illustrate a vertical cross-sectional configuration example of the pixel chip 12. The horizontal cross-section refers to a cross-section parallel to the light emitting surface 15s, and the vertical cross-section refers to a cross-section perpendicular to the light emitting surface 15s. FIG. 10A illustrates a cross-sectional configuration example taken along a line F-F in each of FIGs. 11A to 11E. FIG. 10B illustrates a cross-sectional configuration example taken along a line G-G in each of FIGs. 11A to 11E. FIG. 10C illustrates a cross-sectional configuration example taken along a line H-H in each of FIGs. 11A to 11E. FIG. 10D illustrates a cross-sectional configuration example taken along a line I-I in each of FIGs. 11A to 11E. FIG. 11A illustrates a cross-sectional configuration example taken along a line A-A in each of FIGs. 10A to 10D. FIG. 11B illustrates a cross-sectional configuration example taken along a line B-B in each of FIGs. 10A to 10D. FIG. 11C illustrates a cross-sectional configuration example taken along a line C-C in each of FIGs. 10A to 10D. FIG. 11D illustrates a cross-sectional configuration example taken along a line D-D in each of FIGs. 10A to 10D. FIG. 11E illustrates a cross-sectional configuration example taken along a line E-E in each of FIGs. 10A to 10D.

As described above, the pixel chip 12 includes the three pixels 11G, 11B, and 11R. In the pixel chip 12, the pixels 11G, 11B, and 11R include the respective light emitting elements 15 that emit light of the same color (blue light) regardless of the kinds of the pixels, and include respective optical members, on the light emitting surfaces 15s of the light emitting elements 15, that differ from each other in the color conversion function. That is, in the pixel chip 12, the pixels 11G, 11B, and 11R are configured to emit, by means of the optical members, respective pieces of light that differ from each other in the light emission color.

For example, as illustrated in FIGs. 11A and 11C, the pixel 11G includes the light emitting element 15 and a color conversion section 125G provided on the light emitting surface 15s of the light emitting element 15. The color conversion section 125G corresponds to the above-described optical member. The color conversion section 125G is provided in correspondence with the light emitting element 15 provided immediately below the color conversion section 125G. The light emitting element 15 emits light (blue light) toward the color conversion section 125G via the light emitting surface 15s. The color conversion section 125G performs color conversion (wavelength conversion) on the blue light emitted from the corresponding light emitting element 15. The color conversion section 125G converts the entering blue light into green light, and emits the green light obtained by the color conversion to an opposite side to the light emitting element 15 side. The pixel 11G emits green light having a desired light emission intensity due to driving of the pixel circuit 14 by the gate driver 20 and the data driver 30.

For example, as illustrated in FIGs. 11A and 11D, the pixel 11B includes the light emitting element 15 and a light transmitting section 125C provided on the light emitting surface 15s of the light emitting element 15. The light transmitting section 125C corresponds to the above-described optical member. The light transmitting section 125C is provided in correspondence with the light emitting element 15 provided immediately below the light transmitting section 125C. The light emitting element 15 emits light (blue light) toward the light transmitting section 125C via the light emitting surface 15s. The light transmitting section 125C transmits the blue light emitted from the corresponding light emitting element 15. The light transmitting section 125C transmits the entering blue light, and emits the entering blue light to an opposite side to the light emitting element 15 side. That is, it is not intended that the light transmitting section 125C performs color conversion. The pixel 11B emits blue light having a desired light emission intensity due to driving of the pixel circuit 14 by the gate driver 20 and the data driver 30.

For example, as illustrated in FIGs. 11A and 11E, the pixel 11R includes the light emitting element 15 and a color conversion section 125R provided on the light emitting surface 15s of the light emitting element 15. The color conversion section 125R corresponds to the above-described optical member. The color conversion section 125R is provided in correspondence with the light emitting element 15 provided immediately below the color conversion section 125R. The light emitting element 15 emits light (blue light) toward the color conversion section 125R via the light emitting surface 15s. The color conversion section 125R performs color conversion (wavelength conversion) on the blue light emitted from the corresponding light emitting element 15. The color conversion section 125R converts the entering blue light into red light, and emits the red light obtained by the color conversion to an opposite side to the light emitting element 15 side. The pixel 11R emits red light having a desired light emission intensity due to driving of the pixel circuit 14 by the gate driver 20 and the data driver 30.

### (Light Emitting Element 15)

For example, as illustrated in FIGs. 11A and 11C to 11E, the light emitting element 15 includes a semiconductor layer including a first conductive layer 15a, a light emitting layer 15b, and a second conductive layer 15c that are stacked in this order. The first conductive layer 15a has the light emitting surface 15s. The above-described semiconductor layer includes, for example, a single-crystal multilayered film including GaN and InGaN. The first conductive layer 15a includes, for example, an n-type semiconductor. The light emitting layer 15b includes, for example, a non-doped semiconductor. The second conductive layer 15c includes, for example, a p-type semiconductor.

For example, as illustrated in FIGs. 11A to 11E, the light emitting element 15 further includes a first electrode 16 in contact with the second conductive layer 15c and a second electrode 17 in contact with the first conductive layer 15a. The first electrode 16 is in ohmic contact with the second conductive layer 15c. The first electrode 16 includes, for example, a multilayered film (Ni/Au) of nickel (Ni) and gold (Au). The second electrode 17 is in ohmic contact with the first conductive layer 15a. The second electrode 17 includes, for example, a multilayered film (Ti/Al) of titanium (Ti) and aluminum (Al), or a multilayered film (Cr/Au) of chromium (Cr) and gold (Au).

For example, as illustrated in FIGs. 11C to 11E, in the above-described semiconductor layer, a portion of the first conductive layer 15a, the light emitting layer 15b, and the second conductive layer 15c form a mesa part protruding toward the wiring substrate 13 side. The first electrode 16 is disposed at the top of the mesa part and the second electrode 17 is disposed at the bottom of the mesa part. That is, the second electrode 17 is provided on a surface of the first conductive layer 15a on the opposite side to the light emitting surface 15s, and the first electrode 16 and the second electrode 17 are provided on the surface of the pixel chip 12 on the opposite side to the light emitting surface 15s side.

For example, as illustrated in FIGs. 11C to 11E, the second electrode 17 is shared by the light emitting elements 15 in the pixel chip 12. In addition, for example, as illustrated in FIG. 10B, the first conductive layer 15a is shared by the light emitting elements 15 in the pixel chip 12. That is, in the pixel chip 12, the first conductive layers 15a of the respective light emitting elements 15 are integrally formed. Each of the light emitting elements 15 has a current path P in the first conductive layer 15a from a portion opposed to the first electrode 16 to a portion opposed to the second electrode 17. For example, as illustrated in FIGs. 10B and 11C, the light emitting element 15 of the pixel 11G has a current path Pgc in the first conductive layer 15a from a portion opposed to the first electrode 16G to a portion opposed to the second electrode 17. For example, as illustrated in FIGs. 10B and 11D, the light emitting element 15 of the pixel 11B has a current path Pbc in the first conductive layer 15a from a portion opposed to the first electrode 16B to a portion opposed to the second electrode 17. For example, as illustrated in FIGs. 10B and 11E, the light emitting element 15 of the pixel 11R has a current path Prc in the first conductive layer 15a from a portion opposed to the first electrode 16R to a portion opposed to the second electrode 17. That is, in the pixel chip 12, the first conductive layer 15a has the three current paths Pgc, Pbc, and Prc that are parallel to each other. It is to be noted that because the second electrode 17 extends in the row direction in the pixel chip 12, although respective ends of the current paths Pgc, Pbc, and Prc are provided at parts different from each other, they are provided within a portion of the first conductive layer 15a that is opposed to the second electrode 17.

For example, as illustrated in FIGs. 10B and 11A, the first conductive layer 15a has a trench 15t in a region between the two current paths Pgc and Pbc adjacent to each other. In addition, the first conductive layer 15a has another trench 15t in a region between the two current paths Pbc and Prc adjacent to each other. In addition, for example, as illustrated in FIGs. 10B and 11A, the pixel chip 12 includes a light blocking section 15w in each of the trenches 15t formed in the first conductive layer 15a.

For example, as illustrated in FIGs. 11B to 11E, the pixel chip 12 further includes, other than the light transmitting section 125C provided in the pixel 11B, another light transmitting section 125C (a light transmitting section 125Ca) on a portion of the top surface of the first conductive layer 15a that is opposed to the second electrode 17. For example, as illustrated in FIGs. 11B to 11E, the pixel chip 12 further includes a light blocking layer 129 that covers a surface of the light transmitting section 125Ca on an opposite side to the first conductive layer 15a side.

For example, as illustrated in FIGs. 10A and 11A to 11E, the pixel chip 12 further includes a light blocking section 126 that partitions the color conversion section 125G, the color conversion section 125R, the light transmitting section 125C, and the light transmitting section 125Ca from each other. For example, as illustrated in FIGs. 11A to 11E, the pixel chip 12 may further include a protection layer 127 on an as-needed basis.

In the pixel chip 12, the three first electrodes 16 (16G, 16B, and 16R) each included in the corresponding one of the pixels 11G, 11B, and 11R are, for example, disposed side by side in one line in the column direction, and the second electrode 17 shared by the pixels 11G, 11B, and 11R is, for example, disposed adjacent, in the column direction, to the three electrodes (the G-electrode 13G, the B-electrode 13B, and the R-electrode 13R) disposed side by side in one line in the column direction. In this case, for example, the second electrode 17 extends longer than the first electrode 16 in the column direction and has a size greater than that of the first electrode 16.

### [Effects]

Next, effects of the display apparatus 100 according to the present modification are described.

As with the above-described embodiment, in the present modification, the light emitting elements 15 share the second electrode 17, and only one second electrode 17 is provided in the pixel chip 12. This makes it possible to reduce the number of electrodes per pixel chip 12, as compared with a case where the light emitting elements 15 are provided separately and the second electrode 17 is provided for each of the light emitting elements 15. In addition, in the present modification, the three pixels 11G, 11B, and 11R are disposed side by side in one line in the column direction and are disposed adjacent to the three electrodes (the G-electrode 13G, the B-electrode 13B, and the R-electrode 13R) in the column direction in the pixel chip 12. This makes it possible to increase the size of the second electrode 17. As a result, it is possible to further suppress occurrence of defects due to a bonding error in mounting or the like by a synergetic effect with the reduction of the number of electrodes per pixel chip 12.

### [Modification B]

In the embodiment and the modification thereof described above, for example, as illustrated in FIGs. 12 and 13, multiple trenches 15t may be provided in the region between the two current paths Pgc and Pbc adjacent to each other, and multiple trenches 15t may also be provided in the region between the two current paths Pbc and Prc adjacent to each other. In this case, in the region between the two current paths Pgc and Pbc adjacent to each other, the multiple trenches 15t are disposed in a manner that the multiple trenches 15t block a line straightly connecting the two current paths Pgc and Pbc adjacent to each other. In addition, in the region between the two current paths Pbc and Prc adjacent to each other, the multiple trenches 15t are disposed in a manner that the multiple trenches 15t block a line straightly connecting the two current paths Pbc and Prc adjacent to each other.

In such a case, in the region between the two current paths Pgc and Pbc adjacent to each other, a gap g1 is present between the multiple trenches 15t. Therefore, a current is able to flow between the two current paths Pgc and Pbc adjacent to each other via the gap g1. It is possible, however, to suppress leakage of light (blue light) generated in the pixel 11G into the adjacent pixel 11B and to suppress leakage of light (blue light) generated in the pixel 11B into the adjacent pixel 11G by means of the multiple trenches 15t. Similarly, in the region between the two current paths Pbc and Prc adjacent to each other, a gap g2 is present between the multiple trenches 15t. Therefore, a current is able to flow between the two current paths Pbc and Prc adjacent to each other via the gap g2. It is possible, however, to suppress leakage of light (blue light) generated in the pixel 11B into the adjacent pixel 11R and to suppress leakage of light (blue light) generated in the pixel 11R into the adjacent pixel 11B by means of the multiple trenches 15t. In addition, to expand the current path by providing the gaps g1 and g2 makes it possible to reduce electric resistance on the current paths. As a result, it is possible to reduce electric power consumed upon driving the pixels.

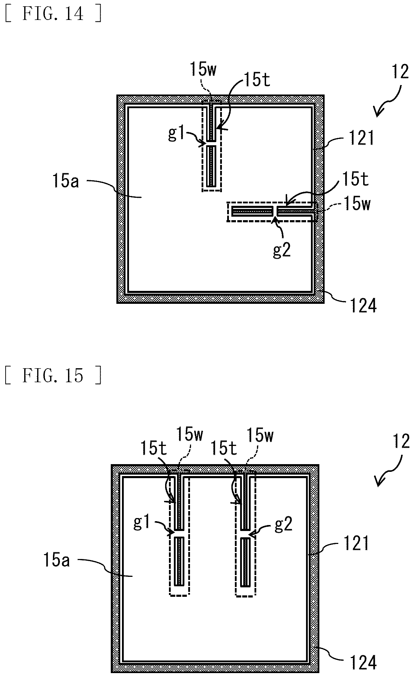

It is to be noted that, as illustrated in FIGs. 14 and 15, in the region between the two current paths Pgc and Pbc adjacent to each other, the multiple trenches 15t may be disposed side by side in one line with a predetermined gap g1 interposed therebetween. In addition, in the region between the two current paths Pbc and Prc adjacent to each other, the multiple trenches 15t may be disposed side by side in one line with a predetermined gap g21 interposed therebetween. In such a case, although light can slightly leak via the gap g1 or g2, it is possible to suppress leakage of light as compared with a case where the multiple trenches 15t are not provided.

### [Modification C]

In the embodiment and the modifications thereof described above, the pixel chip 12 includes the three pixels (11R, 11G, and 11B) that emit respective pieces of light of the three light emission colors of R, G, and B. In the embodiment and the modifications thereof described above, however, the pixel chip 12 may include three pixels that emit respective pieces of light of three light emission colors of a combination other than R, G, and B. In addition, in the embodiment and the modifications thereof described above, the pixel chip 12 may include two pixels or four or more pixels that differ from each other in the light emission color.

In the embodiment and the modifications thereof described above, for example, as illustrated in FIG. 16, the pixel chip 12 may include four pixels 11R, 11B, 11G, and 11Y that differ from each other in the light emission color. In addition, in the embodiment and the modifications thereof described above, for example, as illustrated in FIG. 17, the pixel chip 12 may include two pixels 11B and 11Y that differ from each other in the light emission color. Here, the pixel 11Y is a pixel that emits yellow light, and includes a color conversion section 125Y that converts blue light emitted from the light emitting element 15 into yellow light. In this case, the first electrode 16 of the light emitting element 15 included in the pixel 11Y is electrically coupled to a Y-electrode 13Y of the wiring substrate 13 via a metal bump 128.

For example, the color conversion section 125Y absorbs excitation light (blue light) emitted from the light emitting element 15 and performs wavelength conversion thereon. The color conversion section 125Y includes, for example, a block in which multiple quantum-dot phosphors are fixed with a resin binder. The color conversion section 125Y may further include, for example, a light scatterer that scatters the excitation light (the blue light) emitted from the light emitting element 15. The quantum-dot phosphor absorbs the excitation light (the blue light) emitted from the light emitting element 15 and emits fluorescent light. The quantum-dot phosphor included in the color conversion section 125Y is, for example, a phosphor in a particle form that emits fluorescent light having a wavelength of yellow that is 570 nm or greater and 590 nm or less.

Thus, also in a case where the pixel 11Y including the color conversion section 125Y is provided, the pixel 11Y shares the first conductive layer 15a and the second electrode 17 with the other pixels 11R, 11B, and 11G, and one or multiple trenches 15t (light blocking sections 15w) are provided between the pixel 11Y and a pixel adjacent to the pixel 11Y. Accordingly, in each of the light emitting elements 15, it is possible, by the light blocking section 15w, to reduce leakage of light emitted from the light emitting layer 15b into the first conductive layer 15a of the adjacent light emitting element 15, while securing the current path P. As a result, it is possible to suppress optical crosstalk.

### [Modification D]

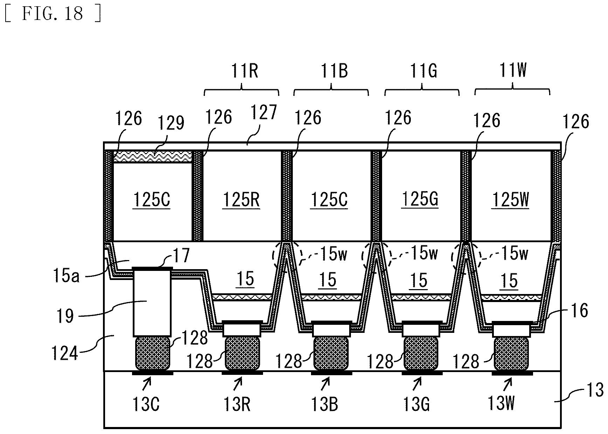

In Modification C described above, for example, as illustrated in FIG. 18, the pixel chip 12 may include four pixels 11R, 11B, 11G, and 11W that differ from each other in the light emission color. Here, the pixel 11W is a pixel that emits white light, and includes a color conversion section 125W that converts blue light emitted from the light emitting element 15 into white light. In this case, the first electrode 16 of the light emitting element 15 included in the pixel 11W is electrically coupled to a W-electrode 13W of the wiring substrate 13 via a metal bump 128.

For example, the color conversion section 125W includes a block with a less content of quantum-dot phosphors that absorb excitation light (blue light) and emit fluorescent light having the wavelength of yellow, as compared with the color conversion section 125Y in Modification C described above. For example, the color conversion section 125W emits white light by mixing the excitation light (the blue light) that passes through the color conversion section 125W and the fluorescent light having the wavelength of yellow emitted from the quantum-dot phosphors.

It is to be noted that, for example, the color conversion section 125W may include, for example, a block in which multiple quantum-dot phosphors that absorb excitation light (blue light) and emit fluorescent light having a wavelength of red and multiple quantum-dot phosphors that absorb excitation light (blue light) and emit fluorescent light having a wavelength of green are fixed with a resin binder. In this case, the color conversion section 125W emits white light, for example, by mixing the excitation light (the blue light) that passes through the color conversion section 125W and the fluorescent light having the wavelength of red and the fluorescent light having the wavelength of green that are emitted from the quantum-dot phosphors included in the block.

Thus, also in a case where the pixel 11W having the color conversion section 125W is provided, the pixel 11W shares the first conductive layer 15a and the second electrode 17 with the other pixels 11R, 11B, and 11G, and one or multiple trenches 15t (light blocking sections 15w) are provided between the pixel 11W and a pixel adjacent to the pixel 11W. Accordingly, in each of the light emitting elements 15, it is possible, by the light blocking section 15w, to reduce leakage of light emitted from the light emitting layer 15b into the first conductive layer 15a of the adjacent light emitting element 15, while securing the current path P. As a result, it is possible to suppress optical crosstalk.

### [Modification E]

In the embodiment and the modifications thereof described above, the pixel chip 12 includes the multiple light emitting elements 15 that emit blue light. For example, as illustrated in FIGs. 19, 20, 21, and 22, however, the pixel chip 12 may include multiple light emitting elements 160 that emit ultraviolet light having a light emission wavelength of 360 nm or greater and 430 nm or less. The light emitting element 160 has a configuration similar to that of the light emitting element 15 except for including a light emitting layer 15b that emits ultraviolet light.

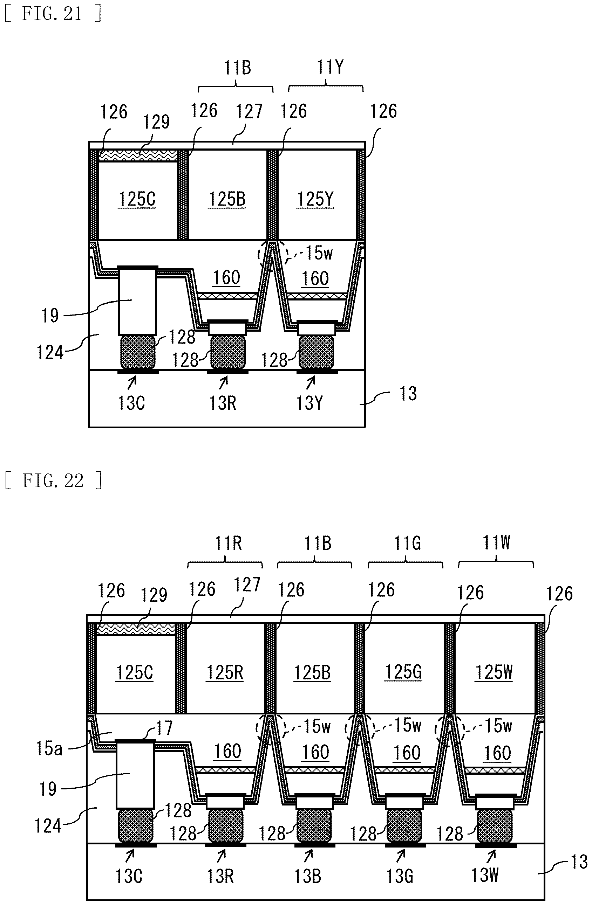

In the present modification, for example, as illustrated in FIGs. 19, 20, and 22, the pixel 11G includes the color conversion section 125G. For example, as illustrated in FIGs. 19 to 22, the pixel 11B includes the color conversion section 125B. For example, as illustrated in FIGs. 19, 20, and 22, the pixel 11R includes the color conversion section 125R. For example, as illustrated in FIGs. 20 and 21, the pixel 11Y includes the color conversion section 125Y. For example, as illustrated in FIG. 22, the pixel 11W includes the color conversion section 125W.

For example, each of the color conversion sections 125G, 125R, 125B, and 125W absorbs excitation light (ultraviolet light) emitted from the light emitting element 160 and performs wavelength conversion thereon. Each of the color conversion sections 125G, 125R, 125B, and 125W may further include, for example, a light scatterer that scatters the excitation light (the ultraviolet light) emitted from the light emitting element 160. The light scatterer includes, for example, a material having a refractive index different from a refractive index of the resin included in the color conversion sections 125G, 125R, 125B, and 125W.

The quantum-dot phosphor absorbs the excitation light (the ultraviolet light) emitted from the light emitting element 160 and emits fluorescent light. The quantum-dot phosphor included in the color conversion section 125G is, for example, a phosphor in a particle form that emits fluorescent light having a wavelength of green that is 500 nm or greater and 550 nm or less. The quantum-dot phosphor included in the color conversion section 125B is, for example, a phosphor in a particle form that emits fluorescent light having a wavelength of blue that is 430 nm or greater and 500 nm or less. The quantum-dot phosphor included in the color conversion section 125R is, for example, a phosphor in a particle form that emits fluorescent light having a wavelength of red that is 610 nm or greater and 780 nm or less. The quantum-dot phosphor included in the color conversion section 125Y is, for example, a phosphor in a particle form that emits fluorescent light having a wavelength of yellow that is 570 nm or greater and 590 nm or less. The quantum-dot phosphor included in the color conversion section 125W is, for example, a phosphor in a particle form that emits fluorescent light having the wavelength of yellow that is 570 nm or greater and 590 nm or less. The multiple quantum-dot phosphors included in the color conversion section 125W may include, for example, multiple phosphors in a particle form that emit fluorescent light having the wavelength of red that is 610 nm or greater and 780 nm or less and multiple phosphors in a particle form that emit fluorescent light having the wavelength of green that is 500 nm or greater and 550 nm or less.

The quantum-dot phosphor includes, for example, a solid solution or a multilayered structure including one or more kinds of materials selected from CdS, CdSe, ZnS, ZnSe, InAgS, and CsPbClₓBr₃₋ₓ. For example, the quantum dot phosphor may be a material obtained by dispersing phosphor particles of an oxide, a fluoride, or a nitride and solidifying them, or may be an organic phosphor.

The resin to be mixed with the quantum dot phosphors is a resin for uniformly dispersing the quantum dot phosphors, and includes, for example, a material having light transparency for light (ultraviolet light) emitted from the light emitting element 160. The resin to be mixed with the quantum dot phosphors includes, for example, an acrylic-based, epoxy-based, or silicone-based resin material.

The light emitting elements 160 of the pixel chip 12 share the second electrode 17 with each other. In addition, the light emitting elements 160 of the pixel chip 12 share the first conductive layer 15a with each other. That is, in the pixel chip 12, the first conductive layers 15a of the respective light emitting elements 160 are integrally formed. Each of the light emitting elements 160 includes a current path P in the first conductive layer 15a from a portion opposed to the first electrode 16 to a portion opposed to the second electrode 17. The first conductive layer 15a is provided with one or multiple trenches 15t in a region between two current paths P adjacent to each other. A light blocking section 15w is provided in each of the trenches 15t formed in the first conductive layer 15a.

### [Operation]

Next, an operation of the display apparatus 100 according to the present modification is described.

### (Display Apparatus 100 Provided with Pixel Chip 12 Illustrated in FIG. 19)

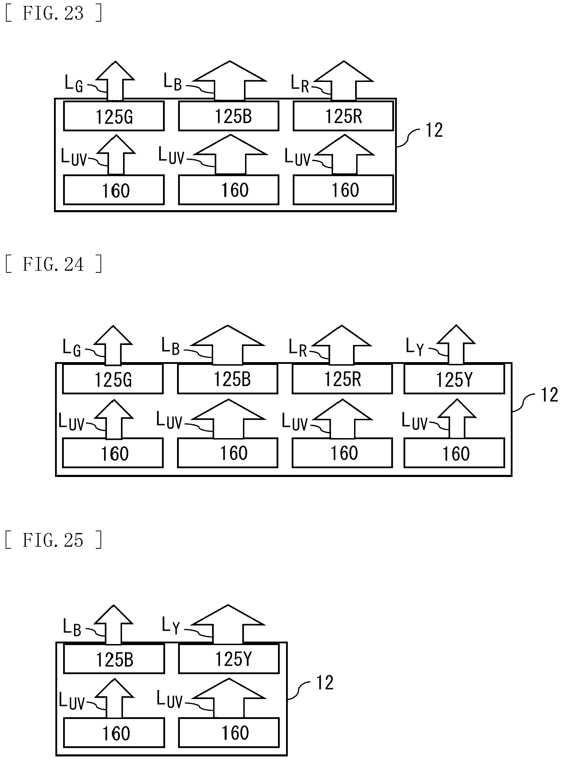

Each of the light emitting elements 160 in the pixel chip 12 is driven by the gate driver 20 and the data driver 30 to thereby emit ultraviolet light Luv having a predetermined light emission intensity, for example, as illustrated in FIG. 23. The ultraviolet light Luv emitted from the first light emitting element 160 in the pixel chip 12 is converted into green light L_{G} by the color conversion section 125G, and the converted light (the green light L_{G}) is emitted to the outside as light of the pixel 11G. In addition, the ultraviolet light Luv emitted from the second light emitting element 160 in the pixel chip 12 is converted into blue light L_{B} by the color conversion section 125B, and the converted light (the blue light L_{B}) is emitted to the outside as light of the pixel 11B. The ultraviolet light Luv emitted from the third light emitting element 160 in the pixel chip 12 is converted into red light L_{R} by the color conversion section 125R, and the converted light (the red light L_{R}) is emitted to the outside as light of the pixel 11R. Three pieces of light (the green light L_{G}, the blue light L_{B}, and the red light L_{R}) that differ from each other in the light emission color are emitted at predetermined respective intensities from each of the pixel chips 12 disposed on the mounting substrate 110A. The three pieces of light (the green light L_{G}, the blue light L_{B}, and the red light L_{R}) that differ from each other in the light emission color and are emitted from each of the pixel chips 12 disposed on the mounting substrate 110A form image light. Entering of the image light into the retina of the user allows the user to recognize that an image is displayed on the display panel 110.

### (Display Apparatus 100 Provided with Pixel Chip 12 Illustrated in FIG. 20)

Each of the light emitting elements 160 in the pixel chip 12 is driven by the gate driver 20 and the data driver 30 to thereby emit ultraviolet light Luv having a predetermined light emission intensity, for example, as illustrated in FIG. 24. The ultraviolet light Luv emitted from the first light emitting element 160 in the pixel chip 12 is converted into green light L_{G} by the color conversion section 125G, and the converted light (the green light L_{G}) is emitted to the outside as light of the pixel 11G. In addition, the ultraviolet light Luv emitted from the second light emitting element 160 in the pixel chip 12 is converted into blue light L_{B} by the color conversion section 125B, and the converted light (the blue light L_{B}) is emitted to the outside as light of the pixel 11B. The ultraviolet light Luv emitted from the third light emitting element 160 in the pixel chip 12 is converted into red light L_{R} by the color conversion section 125R, and the converted light (the red light L_{R}) is emitted to the outside as light of the pixel 11R. The ultraviolet light Luv emitted from the fourth light emitting element 160 in the pixel chip 12 is converted into yellow light L_{Y} by the color conversion section 125Y, and the converted light (the yellow light L_{Y}) is emitted to the outside as light of the pixel 11Y. Four pieces of light (the green light L_{G}, the blue light L_{B}, the red light L_{R}, and the yellow light L_{Y}) that differ from each other in the light emission color are emitted at predetermined respective intensities from each of the pixel chips 12 disposed on the mounting substrate 110A. The four pieces of light (the green light L_{G}, the blue light L_{B}, the red light L_{R}, and the yellow light L_{Y}) that differ from each other in the light emission color and are emitted from each of the pixel chips 12 disposed on the mounting substrate 110A form image light. Entering of the image light into the retina of the user allows the user to recognize that an image is displayed on the display panel 110.

### (Display Apparatus 100 Provided with Pixel Chip 12 Illustrated in FIG. 21)

Each of the light emitting elements 160 in the pixel chip 12 is driven by the gate driver 20 and the data driver 30 to thereby emit ultraviolet light Luv having a predetermined light emission intensity, for example, as illustrated in FIG. 25. The ultraviolet light Luv emitted from the first light emitting element 160 in the pixel chip 12 is converted into blue light L_{B} by the color conversion section 125B, and the converted light (the blue light L_{B}) is emitted to the outside as light of the pixel 11B. The ultraviolet light Luv emitted from the second light emitting element 160 in the pixel chip 12 is converted into yellow light L_{Y} by the color conversion section 125Y, and the converted light (the yellow light L_{Y}) is emitted to the outside as light of the pixel 11Y. Two pieces of light (the blue light L_{B} and the yellow light L_{Y}) that differ from each other in the light emission color are emitted at predetermined respective intensities from each of the pixel chips 12 disposed on the mounting substrate 110A. The two pieces of light (the blue light L_{B} and the yellow light L_{Y}) that differ from each other in the light emission color and are emitted from each of the pixel chips 12 disposed on the mounting substrate 110A form image light. Entering of the image light into the retina of the user allows the user to recognize that an image is displayed on the display panel 110.

### (Display Apparatus 100 Provided with Pixel Chip 12 Illustrated in FIG. 22)

Each of the light emitting elements 160 in the pixel chip 12 is driven by the gate driver 20 and the data driver 30 to thereby emit ultraviolet light Luv having a predetermined light emission intensity, for example, as illustrated in FIG. 26. The ultraviolet light Luv emitted from the first light emitting element 160 in the pixel chip 12 is converted into green light L_{G} by the color conversion section 125G, and the converted light (the green light L_{G}) is emitted to the outside as light of the pixel 11G. In addition, the ultraviolet light Luv emitted from the second light emitting element 160 in the pixel chip 12 is converted into blue light L_{B} by the color conversion section 125B, and the converted light (the blue light L_{B}) is emitted to the outside as light of the pixel 11B. The ultraviolet light Luv emitted from the third light emitting element 160 in the pixel chip 12 is converted into red light L_{R} by the color conversion section 125R, and the converted light (the red light L_{R}) is emitted to the outside as light of the pixel 11R. The ultraviolet light Luv emitted from the fourth light emitting element 160 in the pixel chip 12 is converted into white light L_{Y} by the color conversion section 125W, and the converted light (the white light Lw) is emitted to the outside as light of the pixel 11W. Four pieces of light (the green light L_{G}, the blue light L_{B}, the red light L_{R}, and the white light Lw) that differ from each other in the light emission color are emitted at predetermined respective intensities from each of the pixel chips 12 disposed on the mounting substrate 110A. The four pieces of light (the green light L_{G}, the blue light L_{B}, the red light L_{R}, and the white light Lw) that differ from each other in the light emission color and are emitted from each of the pixel chips 12 disposed on the mounting substrate 110A form image light. Entering of the image light into the retina of the user allows the user to recognize that an image is displayed on the display panel 110.

In the present modification, as with the embodiment and the modifications thereof described above, in each of the light emitting elements 160, it is possible, by the light blocking section 15w, to reduce leakage of light emitted from the light emitting layer 15b into the first conductive layer 15a of the adjacent light emitting element 15, while securing the current path P. As a result, it is possible to suppress optical crosstalk.

### [Modification F]

In the embodiment and the modifications thereof described above, for example, as illustrated in FIG. 27, the pixel chip 12 may include a color filter 170 above the optical element 15 and an optical member 125a provided for each pixel. The optical member 125a is, for example, a member corresponding to the color conversion section 125G, the color conversion section 125R, or the color conversion section 125Y, and may include a protection layer 127 on an as-needed basis.

The color filter 170 provided immediately above the member corresponding to the color conversion section 125G is a member that selectively transmits green light included in the light emitted from the member corresponding to the color conversion section 125G. The color filter 170 provided immediately above the member corresponding to the color conversion section 125R is a member that selectively transmits red light included in the light emitted from the member corresponding to the color conversion section 125R. The color filter 170 provided immediately above the member corresponding to the color conversion section 125Y is a member that selectively transmits yellow light included in the light emitted from the member corresponding to the color conversion section 125Y. That is, the color filter 170 is a filter that attenuates a blue light component emitted from the light emitting element 160 and leaked from the optical member 125a.

In the present modification, the color filter 170 that attenuates the blue light component leaked from the optical member 125a is provided. This makes it possible to provide the user with image light having high color purity.

### [Modification G]

In the embodiment and the modifications thereof described above, for example, as illustrated in FIG. 28, the pixel chip 12 may include a color filter 170 above an optical element 160 and an optical member 125b provided for each pixel. The optical member 125b is, for example, a member corresponding to the color conversion section 125G, the color conversion section 125B, the color conversion section 125R, the color conversion section 125Y, or the color conversion section 125W, and may include a protection layer 127 on an as-needed basis.

The color filter 170 provided immediately above the member corresponding to the color conversion section 125G is a member that selectively transmits green light included in the light emitted from the member corresponding to the color conversion section 125G. The color filter 170 provided immediately above the member corresponding to the color conversion section 125B is a member that selectively transmits blue light included in the light emitted from the member corresponding to the color conversion section 125B. The color filter 170 provided immediately above the member corresponding to the color conversion section 125R is a member that selectively transmits red light included in the light emitted from the member corresponding to the color conversion section 125R. The color filter 170 provided immediately above the member corresponding to the color conversion section 125Y is a member that selectively transmits yellow light included in the light emitted from the member corresponding to the color conversion section 125Y. The color filter 170 provided immediately above the member corresponding to the color conversion section 125W is a member that selectively transmits blue light, red light, and green light included in the light emitted from the member corresponding to the color conversion section 125W. That is, the color filter 170 is a filter that attenuates an ultraviolet light component emitted from the light emitting element 160 and leaked from the optical member 125b.

In the present modification, the color filter 170 that attenuates the ultraviolet light component leaked from the optical member 125b is provided. This makes it possible to provide the user with image light having less ultraviolet component that can adversely influence the user's eyes.

It is to be noted that, in the present modification, the color filter 170 provided immediately above the member corresponding to the color conversion section 125G, 125R, or 125Y may be a filter that attenuates not only the ultraviolet light component but also the blue light component. In this case, it is possible to provide the user with image light that has less ultraviolet light component that can adversely influence the user's eyes and also has high color purity.

### [Modification H]

In the embodiment and the modifications thereof described above, the light transmitting section 125C may be provided for at least one light emitting element 15. The light transmitting section 125C transmits light emitted from the light emitting element 15. In such a case, it is possible to provide a pixel having a color component of the light emitted from the light emitting element 15 in the pixel chip 12 without using a phosphor. Therefore, it is possible to obtain a pixel having a desired light emission intensity that does not depend on the conversion efficiency of the phosphor or the like.

Although the present disclosure has been described above with reference to the embodiments, the present disclosure is not limited to the embodiments described above and various modifications can be made. It is to be noted that the effects described herein are mere examples. The effects of the present disclosure are not limited to the effects described herein. The present disclosure may have effects other than the effects described herein.

According to the light emitting device and the display apparatus according to one aspect of the present disclosure, the first conductive layer is provided with the one or multiple trenches in the region between the two current paths adjacent to each other, and the light blocking section is provided in the one or multiple trenches. Accordingly, it is possible to reduce, by the light blocking section, leakage of light emitted from the light emitting layer into the first conductive layer of the adjacent light emitting element while securing the current path in each of the light emitting elements. As a result, it is possible to suppress optical crosstalk, as compared with a case where such a light blocking section is not provided. It is to be noted that the effects of the present disclosure are not necessarily limited to the effects described here and may include any of the effects described herein.

The present application claims the priority on the basis of Japanese Patent Application No. 2020-096343 filed with the Japan Patent Office on June 2, 2020.

It should be understood by those skilled in the art that various modifications, combinations, sub-combinations, and alterations may occur depending on design requirements and other factors insofar as they are within the scope of the appended claims.

## Claims

1. A light emitting device (12) comprising
multiple light emitting elements (15) each including a semiconductor layer (15a-c) and each including a first electrode (16) and a second electrode (17), the semiconductor layer including a first conductive layer (15a), a light emitting layer (15b), and a second conductive layer (15c) that are stacked in this order, the first conductive layer having a light emitting surface (15s),
the first electrode being in contact with the second conductive layer, the second electrode being in contact with the first conductive layer, the multiple light emitting elements each emitting light from the light emitting layer via the light emitting surface, wherein
the light emitting elements share the first conductive layer and the second electrode with each other,
the light emitting elements each include a current path (P) in the first conductive layer from a portion opposed to the first electrode to a portion opposed to the second electrode,
the first conductive layer has one or multiple trenches (15t), and
the light emitting device further includes a first light blocking section (15w) provided in the one or multiple trenches,
**characterised in that** the one or multiple trenches are in a region between two current paths adjacent to each other.

2. The light emitting device according to claim 1, wherein
the one or multiple trenches are provided to run through the first conductive layer, and
the first light blocking section is provided at least on a light emitting surface side in the one or multiple trenches.

3. The light emitting device according to claim 2, wherein the first light blocking section is provided along an inner wall in the one or multiple trenches and serves as a reflection mirror that reflects light emitted from the light emitting layer.

4. The light emitting device according to claim 1, wherein the multiple trenches are disposed either i) side by side in one line with a predetermined gap therebetween or ii) in a manner that the multiple trenches block a line straightly connecting the two current paths adjacent to each other.

5. The light emitting device according to claim 1, wherein
the light emitting elements each comprise an element that emits blue light, and
the light emitting device further includes
one or multiple color conversion sections provided on a one-to-one basis for one or multiple second light emitting elements other than at least one first light emitting element among the multiple light emitting elements, the one or multiple color conversion sections each performing color conversion on blue light emitted from corresponding one of the second light emitting elements, and
a second light blocking section that is provided at least at a position opposed to the light blocking section and partitions the multiple color conversion sections from each other.

6. The light emitting device according to claim 5, wherein the multiple color conversion sections include a first conversion section that converts the blue light into green light and a second conversion section that converts the blue light into red.

7. The light emitting device according to claim 6, wherein the multiple color conversion sections further include a third conversion section that converts the blue light into yellow light or white light.

8. The light emitting device according to claim 5, wherein the one color conversion section converts the blue light into yellow light.

9. The light emitting device according to claim 5, further comprising a filter section that attenuates a blue light component included in light emitted from the one or multiple color conversion sections.

10. The light emitting device according to claim 5, wherein the one or multiple color conversion sections each include either i) a block including a phosphor and a light scatterer or ii) a block in which a phosphor is fixed with a binder.

11. The light emitting device according to claim 1, wherein
the light emitting elements are each an element that emits ultraviolet light, and
the light emitting device further includes
multiple color conversion sections that are provided on a one-to-one basis for the multiple light emitting elements and each perform color conversion on ultraviolet light emitted from corresponding one of the light emitting elements, and
a second light blocking section that is provided at least at a position opposed to the light blocking section and partitions the multiple color conversion sections from each other.

12. The light emitting device according to claim 11, wherein the multiple color conversion sections include a first conversion section that converts the ultraviolet light into green light, a second conversion section that converts the ultraviolet light into red, and a third conversion section that converts the ultraviolet light into blue light.

13. The light emitting device according to claim 12, wherein the multiple color conversion sections further include a fourth conversion section that converts the ultraviolet light into yellow light or white light.

14. The light emitting device according to claim 11, wherein the one color conversion section converts the ultraviolet light into yellow light.

15. A display apparatus (100) comprising
multiple pixels each including multiple light emitting elements (15)
wherein
the light emitting elements each include a semiconductor layer (15a-c) and each include a first electrode (16) and a second electrode (17), the semiconductor layer including
a first conductive layer (15a), a light emitting layer (15b), and a second conductive layer (15c) that are stacked in this order, the first conductive layer having a light emitting surface (15s),
the first electrode being in contact with the second conductive layer, the second electrode being in contact with the first conductive layer, the light emitting elements each emitting light from the light emitting layer via the light emitting surface,
the light emitting elements share the first conductive layer and the second electrode with each other,
the light emitting elements each include a current path (P) in the first conductive layer from a portion opposed to the first electrode to a portion opposed to the second electrode,
the first conductive layer has one or multiple trenches, and
the pixels each further include a first light blocking section provided in the one or multiple trenches,
**characterised in that** the one or multiple trenches are in a region between two current paths adjacent to each other.

## Patentansprüche

1. Lichtemittierende Vorrichtung (12), umfassend
mehrere Lichtemissionselemente (15), die jeweils eine Halbleiterschicht (15a-c) und jeweils eine erste Elektrode (16) und eine zweite Elektrode (17) einschließen, wobei die Halbleiterschicht eine erste leitfähige Schicht (15a), eine Lichtemissionsschicht (15b) und eine zweite leitfähige Schicht (15c) umfasst, die in dieser Reihenfolge gestapelt sind, wobei die erste leitfähige Schicht eine Lichtemissionsoberfläche (15s) aufweist,
wobei die erste Elektrode in Kontakt mit der zweiten leitfähigen Schicht steht, die zweite Elektrode in Kontakt mit der ersten leitfähigen Schicht steht, die mehreren Lichtemissionselemente jeweils Licht von der Lichtemissionsschicht über die Lichtemissionsoberfläche emittieren, wobei
die Lichtemissionselemente sich die erste leitfähige Schicht und die zweite Elektrode teilen,
die Lichtemissionselemente jeweils einen Strompfad (P) in der ersten leitfähigen Schicht von einem der ersten Elektrode gegenüberliegenden Teil zu einem der zweiten Elektrode gegenüberliegenden Teil einschließen,
die erste leitfähige Schicht einen oder mehrere Gräben (15t) aufweist, und
die Lichtemissionsvorrichtung ferner einen ersten Lichtblockierabschnitt (15w) einschließt, der in dem einen oder den mehreren Gräben bereitgestellt ist, **dadurch gekennzeichnet, dass** der eine oder die mehreren Gräben in einem Bereich zwischen zwei nebeneinanderliegenden Strompfaden liegen.

2. Lichtemissionsvorrichtung nach Anspruch 1, wobei
der eine oder die mehreren Gräben so bereitgestellt sind, dass sie durch die erste leitfähige Schicht verlaufen, und
der erste Lichtblockierabschnitt an mindestens einer Lichtemissionsoberflächenseite in dem einen oder den mehreren Gräben bereitgestellt ist.

3. Lichtemissionsvorrichtung nach Anspruch 2, wobei der erste Lichtblockierabschnitt entlang einer Innenwand in dem einen oder den mehreren Gräben bereitgestellt ist und als Reflexionsspiegel dient, der von der Lichtemissionsschicht emittiertes Licht reflektiert.

4. Lichtemissionsvorrichtung nach Anspruch 1, wobei die mehreren Gräben entweder i) nebeneinander in einer Linie mit einem vorgegebenen Abstand dazwischen oder ii) auf eine Weise angeordnet sind, in der die mehreren Gräben eine Linie blockieren, die die beiden nebeneinander liegenden Strompfade geradlinig verbindet.

5. Lichtemissionsvorrichtung nach Anspruch 1, wobei
die Lichtemissionselemente jeweils ein Element umfassen, das blaues Licht emittiert, und
die Lichtemissionsvorrichtung ferner einschließt
ein oder mehrere Farbumwandlungsabschnitte, die auf einer Eins-zu-eins-Basis für ein oder mehrere zweite Lichtemissionselemente bereitgestellt sind, die nicht mindestens ein erstes Lichtemissionselement von den mehreren Lichtemissionselementen sind, wobei jeder der einen oder mehreren Farbumwandlungsabschnitte eine Farbumwandlung an blauem Licht durchführt, das von einem entsprechenden der zweiten Lichtemissionselemente emittiert wird, und
einen zweiten Lichtblockierabschnitt, der zumindest an einer dem Lichtblockierabschnitt gegenüberliegenden Position bereitgestellt ist und die mehreren Farbumwandlungsabschnitte voneinander trennt.

6. Lichtemissionsvorrichtung nach Anspruch 5, wobei die mehreren Farbumwandlungsabschnitte einen ersten Umwandlungsabschnitt einschließen, der das blaue Licht in grünes Licht umwandelt, und einen zweiten Umwandlungsabschnitt, der das blaue Licht in rotes Licht umwandelt.

7. Lichtemissionsvorrichtung nach Anspruch 6, wobei die mehreren Farbumwandlungsabschnitte ferner einen dritten Umwandlungsabschnitt einschließen, der das blaue Licht in gelbes Licht oder weißes Licht umwandelt.

8. Lichtemissionsvorrichtung nach Anspruch 5, wobei der eine Farbumwandlungsabschnitt das blaue Licht in gelbes Licht umwandelt.

9. Lichtemissionsvorrichtung nach Anspruch 5, ferner umfassend einen Filterabschnitt, der eine blaue Lichtkomponente dämpft, die in dem von einem oder mehreren Farbumwandlungsabschnitten emittierten Licht enthalten ist.

10. Lichtemissionsvorrichtung nach Anspruch 5, wobei der eine oder die mehreren Farbumwandlungsabschnitte jeweils entweder i) einen Block einschließen, der einen Leuchtstoff und einen Lichtstreuer einschließt, oder ii) einen Block, in dem ein Leuchtstoff mit einem Bindemittel fixiert ist.

11. Lichtemissionsvorrichtung nach Anspruch 1, wobei
die Lichtemissionselemente jeweils ein Element sind, das ultraviolettes Licht emittiert, und
die Lichtemissionsvorrichtung ferner einschließt
mehrere Farbumwandlungsabschnitte, die auf einer Eins-zu-eins-Basis für die mehreren Lichtemissionselemente bereitgestellt sind und jeweils eine Farbumwandlung des von einem entsprechenden der Licht emittierenden Elemente emittierten ultravioletten Lichts durchführen, und
einen zweiten Lichtblockierabschnitt, der zumindest an einer dem Lichtblockierabschnitt gegenüberliegenden Position bereitgestellt ist und die mehreren Farbumwandlungsabschnitte voneinander trennt.

12. Lichtemissionsvorrichtung nach Anspruch 11, wobei die mehreren Farbumwandlungsabschnitte einen ersten Umwandlungsabschnitt einschließen, der das ultraviolette Licht in grünes Licht umwandelt, einen zweiten Umwandlungsabschnitt, der das ultraviolette Licht in rotes Licht umwandelt, und einen dritten Umwandlungsabschnitt, der das ultraviolette Licht in blaues Licht umwandelt.

13. Lichtemissionsvorrichtung nach Anspruch 12, wobei die mehreren Farbumwandlungsabschnitte ferner einen vierten Umwandlungsabschnitt einschließen, der das ultraviolette Licht in gelbes Licht oder weißes Licht umwandelt.

14. Lichtemissionsvorrichtung nach Anspruch 11, wobei der eine Farbumwandlungsabschnitt das ultraviolette Licht in gelbes Licht umwandelt.

15. Anzeigeeinrichtung (100), umfassend
mehrere Pixel, die jeweils mehrere Lichtemissionselemente (15) einschließen, wobei
die Lichtemissionselemente jeweils eine Halbleiterschicht (15a-c) und jeweils eine erste Elektrode (16) und eine zweite Elektrode (17) einschließen, wobei die Halbleiterschicht eine erste leitfähige Schicht (15a), eine Lichtemissionsschicht (15b) und eine zweite leitfähige Schicht (15c) einschließt, die in dieser Reihenfolge gestapelt sind, wobei die erste leitfähige Schicht eine Lichtemissionsoberfläche (15s) aufweist,
wobei die erste Elektrode mit der zweiten leitfähigen Schicht in Kontakt steht, die zweite Elektrode mit der ersten leitfähigen Schicht in Kontakt steht, wobei die Lichtemissionselemente jeweils Licht von der Lichtemissionsschicht über die Lichtemissionsoberfläche emittieren,
die Lichtemissionselemente sich die erste leitfähige Schicht und die zweite Elektrode teilen,
die Lichtemissionselemente jeweils einen Strompfad (P) in der ersten leitfähigen Schicht von einem der ersten Elektrode gegenüberliegenden Teil zu einem der zweiten Elektrode gegenüberliegenden Teil einschließen,
die erste leitfähige Schicht einen oder mehrere Gräben aufweist, und
die Pixel jeweils ferner einen ersten Lichtblockierabschnitt einschließen, der in einem oder mehreren Gräben bereitgestellt ist,
**dadurch gekennzeichnet, dass** der eine oder die mehreren Gräben in einem Bereich zwischen zwei nebeneinanderliegenden Strompfaden liegen.

## Revendications

1. Dispositif émetteur de lumière (12) comprenant
de multiples éléments émetteurs de lumière (15) comportant chacun une couche semi-conductrice (15a-c) et comportant chacun une première électrode (16) et une seconde électrode (17), la couche semi-conductrice comportant une première couche conductrice (15a), une couche émettrice de lumière (15b) et une seconde couche conductrice (15c) qui sont empilées dans cet ordre, la première couche conductrice ayant une surface émettrice de lumière (15s),
la première électrode étant en contact avec la seconde couche conductrice, la seconde électrode étant en contact avec la première couche conductrice, les multiples éléments émetteurs de lumière émettant chacun de la lumière à partir de la couche émettrice de lumière par l'intermédiaire de la surface émettrice de lumière, dans lequel
les éléments émetteurs de lumière partagent la première couche conductrice et la seconde électrode les uns avec les autres,
les éléments émetteurs de lumière comportent chacun un trajet de courant (P) dans la première couche conductrice à partir d'une partie opposée à la première électrode jusqu'à une partie opposée à la seconde électrode,
la première couche conductrice a une ou de multiples tranchées (15t), et
le dispositif émetteur de lumière comporte en outre une première section de blocage de lumière (15w) fournie dans la ou les multiples tranchées, **caractérisé en ce que** la ou les multiples tranchées sont dans une région entre deux trajets de courant adjacents l'un à l'autre.

2. Dispositif émetteur de lumière selon la revendication 1, dans lequel
la ou les multiples tranchées sont fournies pour s'étendre à travers la première couche conductrice, et
la première section de blocage de lumière est fournie au moins sur un côté de surface émettrice de lumière dans la ou les multiples tranchées.

3. Dispositif émetteur de lumière selon la revendication 2, dans lequel la première section de blocage de lumière est fournie le long d'une paroi interne dans la ou les multiples tranchées et sert de miroir de réflexion qui réfléchit de la lumière émise à partir de la couche émettrice de lumière.

4. Dispositif émetteur de lumière selon la revendication 1, dans lequel les multiples tranchées sont disposées soit i) côte à côte dans une ligne avec un écartement prédéterminé entre elles soit ii) d'une manière telle que les multiples tranchées bloquent une ligne reliant en ligne droite les deux trajets de courant adjacents l'un à l'autre.

5. Dispositif émetteur de lumière selon la revendication 1, dans lequel
les éléments émetteurs de lumière comprennent chacun un élément qui émet de la lumière bleue, et
le dispositif émetteur de lumière comporte en outre
une ou de multiples sections de conversion de couleur fournies sur une base d'un pour un ou de multiples seconds éléments émetteurs de lumière autres qu'au moins un premier élément émetteur de lumière parmi les multiples éléments émetteurs de lumière, la ou les multiples sections de conversion de couleur mettant en œuvre chacune une conversion de couleur sur de la lumière bleue émise par un correspondant parmi les seconds éléments émetteurs de lumière, et
une seconde section de blocage de lumière qui est fournie au moins au niveau d'une position opposée à la section de blocage de lumière et sépare les multiples sections de conversion de couleur les unes des autres.

6. Dispositif émetteur de lumière selon la revendication 5, dans lequel les multiples sections de conversion de couleur comportent une première section de conversion qui convertit la lumière bleue en lumière verte et une deuxième section de conversion qui convertit la lumière bleue en rouge.

7. Dispositif émetteur de lumière selon la revendication 6, dans lequel les multiples sections de conversion de couleur comportent en outre une troisième section de conversion qui convertit la lumière bleue en lumière jaune ou lumière blanche.

8. Dispositif émetteur de lumière selon la revendication 5, dans lequel la section de conversion de couleur précitée convertit la lumière bleue en lumière jaune.

9. Dispositif émetteur de lumière selon la revendication 5, comprenant en outre une section de filtre qui atténue une composante de lumière bleue incluse dans de la lumière émise par la ou les multiples sections de conversion de couleur.

10. Dispositif émetteur de lumière selon la revendication 5, dans lequel la ou les multiples sections de conversion de couleur comportent chacune soit i) un bloc comportant un luminophore et un diffuseur de lumière soit ii) un bloc dans lequel un luminophore est fixé avec un liant.

11. Dispositif émetteur de lumière selon la revendication 1, dans lequel
les éléments émetteurs de lumière sont chacun un élément qui émet de la lumière ultraviolette, et
le dispositif émetteur de lumière comporte en outre
de multiples sections de conversion de couleur qui sont fournies sur une base d'un pour un pour les multiples éléments émetteurs de lumière et mettent chacune en œuvre une conversion de couleur sur de la lumière ultraviolette émise par l'un correspondant des éléments émetteurs de lumière, et
une seconde section de blocage de lumière qui est fournie au moins au niveau d'une position opposée à la section de blocage de lumière et sépare les multiples sections de conversion de couleur les unes des autres.

12. Dispositif émetteur de lumière selon la revendication 11, dans lequel les multiples sections de conversion de couleur comportent une première section de conversion qui convertit la lumière ultraviolette en lumière verte, une deuxième section de conversion qui convertit la lumière ultraviolette en rouge, et une troisième section de conversion qui convertit la lumière ultraviolette en lumière bleue.

13. Dispositif émetteur de lumière selon la revendication 12, dans lequel les multiples sections de conversion de couleur comportent en outre une quatrième section de conversion qui convertit la lumière ultraviolette en lumière jaune ou lumière blanche.

14. Dispositif émetteur de lumière selon la revendication 11, dans lequel la section de conversion de couleur précitée convertit la lumière ultraviolette en lumière jaune.

15. Appareil d'affichage (100) comprenant
de multiples pixels comportant chacun de multiples éléments émetteurs de lumière (15), dans lequel
les éléments émetteurs de lumière comportent chacun une couche semi-conductrice (15a-c) et comportent chacun une première électrode (16) et une seconde électrode (17), la couche semi-conductrice comportant une première couche conductrice (15a), une couche émettrice de lumière (15b) et une seconde couche conductrice (15c) qui sont empilées dans cet ordre, la première couche conductrice ayant une surface émettrice de lumière (15s),
la première électrode étant en contact avec la seconde couche conductrice, la seconde électrode étant en contact avec la première couche conductrice, les éléments émetteurs de lumière émettant chacun de la lumière à partir de la couche émettrice de lumière par l'intermédiaire de la surface émettrice de lumière,
les éléments émetteurs de lumière partagent la première couche conductrice et la seconde électrode les uns avec les autres,
les éléments émetteurs de lumière comportent chacun un trajet de courant (P) dans la première couche conductrice à partir d'une partie opposée à la première électrode jusqu'à une partie opposée à la seconde électrode,
la première couche conductrice a une ou de multiples tranchées, et
les pixels comportent en outre chacun une première section de blocage de lumière fournie dans la ou les multiples tranchées, **caractérisé en ce que** la ou les multiples tranchées sont dans une région entre deux trajets de courant adjacents l'un à l'autre.
